(19) **Europäisches Patentamt European Patent Office Office européen des brevets**

(11) **EP 4 657 754 A1**

(12) **EUROPEAN PATENT APPLICATION**
published in accordance with Art. 153(4) EPC

(43) Date of publication:
**03.12.2025 Bulletin 2025/49**

(21) Application number: **23918505.1**

(22) Date of filing: **18.10.2023**

(51) International Patent Classification (IPC):
*H03H 11/20* (2006.01)    *H01Q 3/38* (2006.01)
*H01Q 21/00* (2006.01)

(52) Cooperative Patent Classification (CPC):
**H01Q 3/38; H01Q 21/00; H03H 11/20**

(86) International application number:
**PCT/JP2023/037745**

(87) International publication number:
**WO 2024/157550 (02.08.2024 Gazette 2024/31)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **26.01.2023 JP 2023010438**

(71) Applicant: **The Ritsumeikan Trust Kyoto-shi, Kyoto 604-8520 (JP)**

(72) Inventor: **NOSAKA, Hideyuki Kusatsu-shi, Shiga 525-8577 (JP)**

(74) Representative: **Prinz & Partner mbB Patent- und Rechtsanwälte Rundfunkplatz 2 80335 München (DE)**

(54) **SIGNAL GENERATION CIRCUIT**

(57) A control voltage source circuit (11) generates a control voltage (Vc) having one of a plurality of predetermined voltage values, in accordance with an inputted control signal (k). A reference voltage source circuit (12) generates a plurality of predetermined reference voltages (Vr). Folding circuits (13, 14) generate an output signal based on differences between the control voltage (Vc) and the plurality of reference voltages (Vr), the output signal having a signal level corresponding to a predetermined phase of a sine wave or a cosine wave. The control voltage source circuit (11) is provided with a parallel circuit of a plurality of constant current sources (62), each of the constant current sources being turned on or off in accordance with the control signal (k).

FIG. 1

EP 4 657 754 A1

**Description**

TECHNICAL FIELD

The present disclosure relates to a signal generation circuit, a phase shifter, an array antenna apparatus, and a wireless communication apparatus.

BACKGROUND ART

For wireless communication systems of the fifth-generation mobile communication system or later (Beyond 5G), use of a high-frequency band, such as millimeter waves and terahertz waves, has been studied in order to increase communication capacity. Furthermore, in order to increase communication capacity, it is being studied to focus a beam of a radio wave on a communication counterpart using a phased array antenna apparatus. By using the phased array antenna apparatus, it is possible to perform, for example, beam forming (directing a beam in a specific direction), beam steering (directing a beam to a communication counterpart), and beam tracking (continuously directing a beam to a communication counterpart moving at high speed).

In order to implement the phased array antenna apparatus, phase shifters capable of arbitrarily controlling a phase of a local signal are required. For example, Patent Document 1 discloses a vector-synthesis analog phase shifter used for a communication apparatus and a radar apparatus.

CITATION LIST

PATENT DOCUMENTS

PATENT DOCUMENT 1: Japanese patent laid-open publication No. JP 2003-133906 A

SUMMARY OF INVENTION

TECHNICAL PROBLEM

Patent Document 1 discloses reading and setting gains and bias voltages from a storage device to four differential variable gain amplifiers, and combining output signals of the four differential variable gain amplifiers. However, a circuit size and power consumption are increased to store such gains and bias voltages and to process signals based on the gains and bias voltages. In addition, it takes some time to process the signals. Therefore, it is required to shift a phase of a signal with a smaller circuit size and a smaller power consumption than the prior art, and at a higher speed than the prior art.

In addition, the phase shifter is required to have certain tolerance to variations in a process, a voltage, and a temperature (PVT variations). In addition, the phase shifter may be required to have linear control characteristics with respect to a control signal.

An object of the present disclosure is to provide a signal generation circuit that generates a signal to be used to control a phase shifter, the signal generation circuit having a smaller circuit size and a smaller power consumption than the prior art, being operable at a higher speed than the prior art, having tolerance to PVT variations, and having linear control characteristics with respect to a control signal. In addition, a further object of the present disclosure is to provide a phase shifter, an array antenna apparatus, and a wireless communication apparatus provided with such a signal generation circuit.

SOLUTION TO PROBLEM

A signal generation circuit of a first aspect of the present disclosure is provided with: at least one control voltage source circuit, at least one reference voltage source circuit, and at least one folding circuit. The at least one control voltage source circuit generates a control voltage having one of a plurality of predetermined voltage values, in accordance with an inputted control signal. The at least one reference voltage source circuit generates a plurality of predetermined reference voltages. The at least one folding circuit generates an output signal based on differences between the control voltage and the plurality of reference voltages, the output signal having a signal level corresponding to a predetermined phase of a sine wave or a cosine wave. The control voltage source circuit is provided with a parallel circuit of a plurality of first constant current sources, each of the first constant current sources being turned on or off in accordance with the control signal.

According to a signal generation circuit of a second aspect of the present disclosure, the signal generation circuit of the first aspect is further configured as follows. The signal generation circuit is provided with a first folding circuit and a second folding circuit. The first folding circuit generates a first output signal having a signal level corresponding to a predetermined phase of a sine wave. The second folding circuit generates a second output signal having a signal level corresponding to a predetermined phase of a cosine wave.

According to a signal generation circuit of a third aspect of the present disclosure, the signal generation circuit of the second aspect is further configured as follows. The first folding circuit is provided with first to third differential amplifiers. The first differential amplifier compares the control voltage with a first reference voltage to generate a first differential output signal. The second differential amplifier compares the control voltage with a second reference voltage higher than the first reference voltage to generate a second differential output signal. The third differential amplifier compares the control voltage with a third reference voltage higher than the second reference voltage to generate a third differential output signal. The second folding circuit is provided with fourth to sixth differential amplifiers. The fourth differential amplifier compares the control voltage with a fourth reference voltage to generate a fourth differential output signal. The fifth differential amplifier compares the control voltage with a fifth reference voltage higher than the fourth reference voltage to generate a fifth differential output signal. The sixth differential amplifier compares the control voltage with a sixth reference voltage higher than the fifth reference voltage to generate a sixth differential output signal. The first output signal is a sum of the first and third differential output signals and an inverted signal of the second differential output signal. The second output signal is a sum of the fourth and sixth differential output signals and an inverted signal of the fifth differential output signal.

According to a signal generation circuit of a fourth aspect of the present disclosure, the signal generation circuit of the third aspect is further configured as follows. The control voltage source circuit supplies one common control voltage to the first to sixth differential amplifiers. The first to sixth reference voltages are different from each other.

According to a signal generation circuit of a fifth aspect of the present disclosure, the signal generation circuit of the fourth aspect is further configured as follows. The reference voltage source circuit is provided with a plurality of resistors and a plurality of first taps, and generates the first to sixth reference voltages at the plurality of taps.

According to a signal generation circuit of a sixth aspect of the present disclosure, the signal generation circuit of the fourth aspect is further configured as follows. The signal generation circuit is provided with first to sixth reference voltage source circuits that generate the first to sixth reference voltages, respectively. Each of the first to sixth reference voltage source circuits is provided with a parallel circuit of a plurality of second constant current sources, each of the second constant current sources being turned on or off in accordance with a reference voltage to be generated. Each of the first to sixth reference voltage source circuits has components and a layout at least partially identical to components and a layout of the control voltage source circuit.

According to a signal generation circuit of a seventh aspect of the present disclosure, the signal generation circuit of the fourth aspect is further configured as follows. The signal generation circuit is provided with first to third reference voltage source circuits. The first reference voltage source circuit generates the first and sixth reference voltages. The second reference voltage source circuit generates the second and fifth reference voltages. The third reference voltage source circuit generates the third and fourth reference voltages. The first reference voltage source circuit is provided with a parallel circuit of a plurality of second constant current sources, each of the second constant current sources being connected to one of the first and sixth differential amplifiers in accordance with a reference voltage to be generated. The second reference voltage source circuit is provided with a parallel circuit of a plurality of third constant current sources, each of the third constant current sources being connected to one of the second and fifth differential amplifiers in accordance with a reference voltage to be generated. The third reference voltage source circuit is provided with a parallel circuit of a plurality of fourth constant current sources, each of the fourth constant current sources being connected to one of the third and fourth differential amplifiers in accordance with a reference voltage to be generated. Each of the first to third reference voltage source circuits has components and a layout at least partially identical to components and a layout of the control voltage source circuit.

According to a signal generation circuit of an eighth aspect of the present disclosure, the signal generation circuit of the third aspect is further configured as follows. The signal generation circuit is provided with a first control voltage source circuit and a second control voltage source circuit. The first control voltage source circuit generates and supplies a first control voltage to the first to third differential amplifiers. The second control voltage source circuit generates and supplies a second control voltage to the fourth to sixth differential amplifiers, the first and second control voltages having a voltage difference that is constant modulo a difference between a maximum and a minimum of the first control voltage. The fourth to sixth reference voltages are equal to the first to third reference voltages, respectively.

According to a signal generation circuit of a ninth aspect of the present disclosure, the signal generation circuit of the eighth aspect is further configured as follows. The reference voltage source circuit is provided with a plurality of resistors and a plurality of first taps, and generates the first to third reference voltages at the plurality of taps.

According to a signal generation circuit of a tenth aspect of the present disclosure, the signal generation circuit of the eighth aspect is further configured as follows. The signal generation circuit is provided with first to third reference voltage source circuits that generate the first to third reference voltages, respectively. Each of the first to third reference voltage source circuits is provided with a parallel circuit of a plurality of second constant current sources, each of the second constant current sources being turned on or off in accordance with a reference voltage to be generated. Each of the first to third reference voltage source circuits has components and a layout at least partially identical to components and a layout of the control voltage source circuits.

According to a signal generation circuit of an eleventh aspect of the present disclosure, the signal generation circuit of one of the eighth to tenth aspects is further configured as follows. The first control voltage source circuit generates the first control voltage in accordance with the control signal. The second control voltage source circuit generates the second control voltage in accordance with a signal which is a sum of the control signal and a predetermined value.

According to a signal generation circuit of a twelfth aspect of the present disclosure, the signal generation circuit of one of the eighth to tenth aspects is further configured as follows. The second control voltage source circuit is provided with a third constant current source that constantly generates a current corresponding to the voltage difference between the first and second control voltages.

According to a signal generation circuit of a thirteenth aspect of the present disclosure, the signal generation circuit of one of the third to twelfth aspects is further configured as follows. Each of the first to sixth differential amplifiers is provided with a pair of bipolar transistors or a pair of field effect transistors.

A phase sifter of a fourteenth aspect of the present disclosure is provided with: the signal generation circuit according to one of the second to thirteenth aspects, a quadrature splitter, a first multiplier, a second multiplier, and a combiner. The quadrature splitter splits an input signal into an in-phase signal and a quadrature-phase signal. The first multiplier multiplies the in-phase signal by the second output signal of the signal generation circuit to generate a first multiplication signal. The second multiplier multiplies the quadrature-phase signal by the first output signal of the signal generation circuit to generate a second multiplication signal. The combiner combines the first multiplication signal and the second multiplication signal with each other.

According to a phase sifter of a fifteenth aspect of the present disclosure, the phase sifter of the fourteenth aspect is further configured as follows. The phase shifter is further provided with a low-pass filter that reduces signal components of the first and second output signals of the signal generation circuit, the signal components having frequencies higher than a predetermined frequency.

An array antenna apparatus of a sixteenth aspect of the present disclosure is provided with: a plurality of antenna elements; a plurality of mixers; and a plurality of the phase shifters of the fourteenth or fifteenth aspect.

A wireless communication apparatus of a seventeenth aspect of the present disclosure is provided with: the array antenna apparatus of the sixteenth aspect; and a communication circuit.

ADVANTAGEOUS EFFECTS OF INVENTION

According to one aspect of the present disclosure, it is possible to provide a signal generation circuit having a smaller circuit size and a smaller power consumption than the prior art, being operable at a higher speed than the prior art, having tolerance to PVT variations, and having linear control characteristics with respect to a control signal.

BRIEF DESCRIPTION OF DRAWINGS

Fig. 1 is a block diagram showing a configuration of a phase shifter 1 provided with a signal generation circuit 10 according to a first embodiment.

Fig. 2 is a circuit diagram showing a configuration of the signal generation circuit 10 of Fig. 1.

Fig. 3 is a circuit diagram showing a configuration of a control voltage source circuit 11 of Fig. 1.

Fig. 4 is a circuit diagram explaining an operation of the control voltage source circuit 11 of Fig. 1.

Fig. 5 is a circuit diagram showing an exemplary configuration of differential amplifiers 31 to 33 and 41 to 43 of Fig. 2.

Fig. 6 is a circuit diagram showing another exemplary configuration of the differential amplifiers 31 to 33 and 41 to 43 of Fig. 2.

Fig. 7 is a graph schematically showing operation characteristics of each of the differential amplifiers 31 to 33 and 41 to 43 of Fig. 2.

Fig. 8 is a graph schematically showing changes in operation characteristics in cases where different reference voltages Vr2 and Vr4 are set for a pair of the differential amplifiers 31 and 32 of Fig. 2.

Fig. 9 is a graph explaining that the pair of differential amplifiers 31 and 32 of Fig. 2 can generate a signal having a waveform similar to a sine wave.

Fig. 10 is a diagram explaining a relationship among a control voltage Vc(k), reference voltages Vr, and output signals Vsin(k) and Vcos(k) of Fig. 1.

Fig. 11 is a block diagram showing a configuration of a phase shifter 1A provided with a signal generation circuit 10A according to a second embodiment.

Fig. 12 is a circuit diagram showing a configuration of the signal generation circuit 10A of Fig. 11.

Fig. 13 is a diagram explaining operations of control voltage source circuits 11a and 11b of Fig. 11.

Fig. 14 is a diagram explaining a relationship among control voltages Vca(k) and Vcb(k), reference voltages Vr, and output signals Vsin(k) and Vcos(k) of Fig. 11.

Fig. 15 is a block diagram showing a configuration of a phase shifter 1B provided with a signal generation circuit 10B according to a third embodiment.

Fig. 16 is a circuit diagram showing a configuration of the signal generation circuit 10B of Fig. 15.

Fig. 17 is a diagram explaining operations of control voltage source circuits 11a and 11Bb of Fig. 15.

Fig. 18 is a diagram explaining a relationship among control voltages Vca(k) and Vcb(k), reference voltages Vr, and output signals Vsin(k) and Vcos(k) of Fig. 15.

Fig. 19 is a block diagram showing a configuration of a phase shifter 1C provided with a signal generation circuit 10C according to a fourth embodiment.

Fig. 20 is a circuit diagram showing a configuration of the signal generation circuit 10C of Fig. 19.

Fig. 21 is a circuit diagram showing a configuration of a signal generation circuit 10D according to a variation of the fourth embodiment.

Fig. 22 is a block diagram showing a configuration of a phase shifter 1E provided with a signal generation circuit 10E according to a fifth embodiment.

Fig. 23 is a circuit diagram showing a configuration of the signal generation circuit 10E of Fig. 22.

Fig. 24 is a diagram explaining operations of reference voltage source circuits 12E-1 to 12E-6 of Fig. 22.

Fig. 25 is a block diagram showing a configuration of a phase shifter 1F provided with a signal generation circuit 10F according to a sixth embodiment.

Fig. 26 is a circuit diagram showing a configuration of the signal generation circuit 10F of Fig. 25.

Fig. 27 is a diagram explaining operations of reference voltage source circuits 12F-1 to 12F-3 of Fig. 25.

Fig. 28 is a block diagram showing a configuration of a phase shifter 1G provided with the signal generation circuit 10 according to a seventh embodiment.

Fig. 29 is a block diagram showing a configuration of a wireless communication apparatus 100 according to an eighth embodiment.

DESCRIPTION OF EMBODIMENTS

Hereinafter, with reference to the drawings, we will describe a signal generation circuit, a phase shifter, an array antenna apparatus, and a wireless communication apparatus according to embodiments of the present disclosure. The same reference signs denote the similar components throughout the drawings.

[FIRST EMBODIMENT]

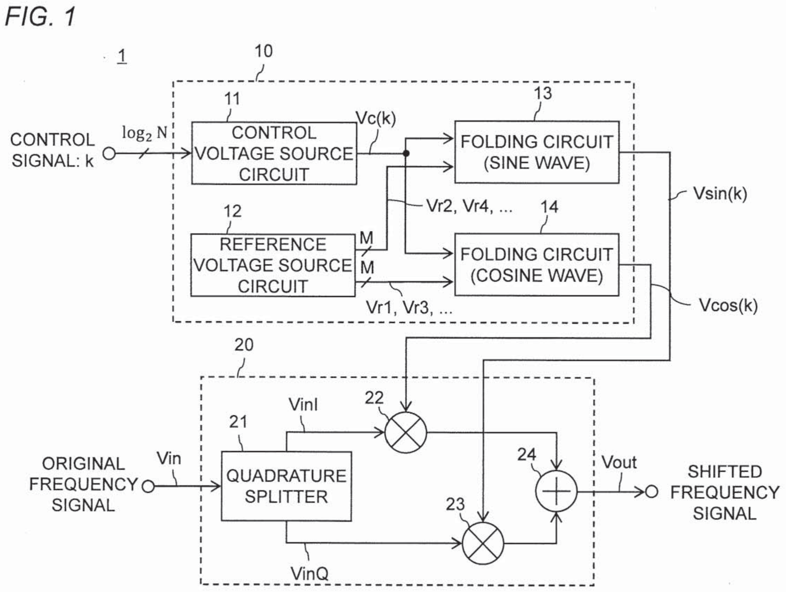

Fig. 1 is a block diagram showing a configuration of a phase shifter 1 provided with a signal generation circuit 10 according to a first embodiment. The phase shifter 1 is provided with the signal generation circuit 10 and a quadrature modulation circuit 20.
The signal generation circuit 10 is provided with a control voltage source circuit 11, a reference voltage source circuit 12, and folding circuits 13 and 14. The control voltage source circuit 11 generates a control voltage Vc(k) having one of a plurality of N predetermined voltage values in accordance with an inputted control signal k. The control signal k is a digital signal that takes any integer from k = {0, 1, ..., N-1}. The control signal k has a size of $\log_2 N$ bits. The reference voltage source circuit 12 generates a plurality of 2M predetermined reference voltages Vr1, ... , Vr2M . The folding circuit 13 generates an output signal Vsin(k) bases on differences between the control voltage Vc(k) and the reference voltages Vr2, Vr4, ... , Vr2M, the output signal Vsin(k) having a signal level corresponding to a predetermined phase of a sine wave. The folding circuit 14 generates an output signal Vcos(k) based on differences between the control voltage Vc(k) and the reference voltages Vr1, Vr3, ... , Vr(2M-1), the output signal Vcos(k) having a signal level corresponding to a predetermined phase of a cosine wave.
The quadrature modulation circuit 20 is provided with a quadrature splitter 21, multipliers 22 and 23, and a combiner 24. The quadrature splitter 21 splits an inputted original frequency signal Vin, to an I-component signal VinI and a Q-component signal VinQ. The multiplier 22 multiplies the I-component signal VinI by the signal Vcos(k) outputted from the folding circuit 14. The multiplier 23 multiplies the Q-component signal VinQ by the signal Vsin(k) outputted from the folding circuit 13. When each of the multipliers 22 and 23 is supplied with two analog signals, it outputs a product of the two analog signals. Each of the multipliers 22 and 23 may be, for example, a four-quadrant multiplier or a variable gain amplifier. The combiner 24 combines the output signals of the multipliers 22 and 23 with each other, and outputs a phase-shifted frequency signal Vout.
Here, an operation principle of the quadrature modulation circuit 20 will be described. The original frequency signal Vin is expressed, as a sine wave having an angular frequency ω, by Vin = sin(ωt). Furthermore, the following signals Vsin(k) and Vcos(k) are inputted from the signal generation circuit 10.

[Mathematical Expression 1]

$$Vsin(k) = \sin\left(k\frac{M-1}{2N}\pi\right)$$

[Mathematical Expression 2]

$$Vcos(k) = \cos\left(k\frac{M-1}{2N}\pi\right)$$

The quadrature splitter 21 generates two signals VinI = sin(ωt) and VinQ = cos(ωt) having phases shifted by 90 degrees. Next, the multipliers 22 and 23 multiply the signals VinI and VinQ by the signals Vcos(k) and Vsin(k) inputted from the signal generation circuit 10, respectively. The combiner 24 combines the output signals of the multipliers 22 and 23 with each other, and outputs the phase-shifted frequency signal Vout. Therefore, the phase-shifted frequency signal Vout is expressed as follows.

[Mathematical Expression 3]

$$Vout = VinI \cdot Vcos(k) + VinQ \cdot Vsin(k)$$

$$= \sin(\omega t) \cos\left(k\frac{M-1}{2N}\pi\right) + \cos(\omega t) \sin\left(k\frac{M-1}{2N}\pi\right)$$

$$= \sin\left(\omega t + k\frac{M-1}{2N}\pi\right)$$

Comparing the original frequency signal Vin with the phase-shifted frequency signal Vout, it can be seen that the phase shifter 1 generates an output signal having a phase shift proportional to the value of the control signal k.

The signal generation circuit 10 operates as a control circuit for the quadrature modulation circuit 20, and controls the phase shift of the signal Vin in the quadrature modulation circuit 20.

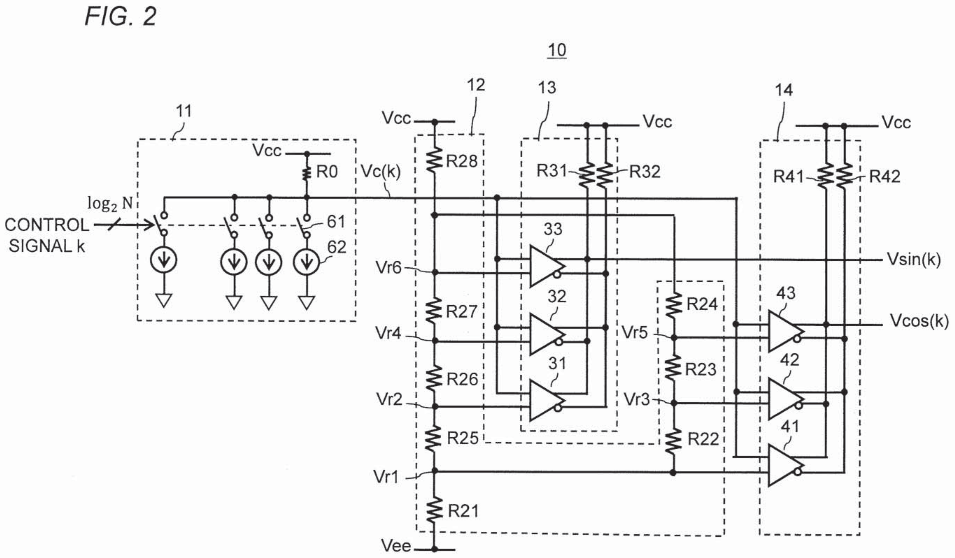

Fig. 2 is a circuit diagram showing a configuration of the signal generation circuit 10 of Fig. 1.

The control voltage source circuit 11 is provided with a resistor R0, a plurality of switches 61, and a plurality of constant current sources 62. Each of the constant current sources 62 is connected to the resistor R0 via a corresponding switch 61. In other words, a plurality of series circuits, each including the switch 61 and the constant current source 62, are connected parallel to each other. The switches 61 have the same characteristics with each other. The constant current sources 62 also have the same characteristics with each other, and each generates a predetermined current I. By turning on and off the switches 61 in accordance with the control signal k, the currents from the constant current sources 62 corresponding to closed switches 61 flow through the resistor R0. As a result, the control voltage Vc(k) occurs, having one of the plurality of N predetermined voltage values in accordance with the control signal k. The control voltage source circuit 11 is functionally configured in a manner similar to that of a $\log_2 N$-bit current-output digital-to-analog converter.

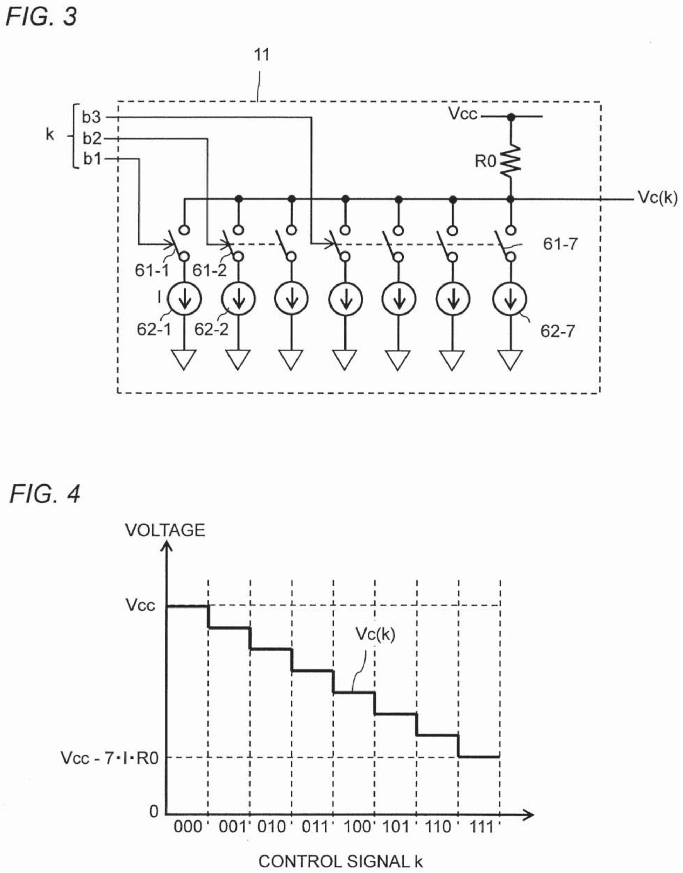

Fig. 3 is a circuit diagram showing a configuration of the control voltage source circuit 11 of Fig. 1. Fig. 3 indicates an exemplary case of N = 8, in which the control signal k consists of $\log_2 N = 3$ bits, b1 to b3, wherein b1 is a least significant bit, and b3 is a most significant bit. The control voltage source circuit 11 is provided with $2^3 - 1 =$ seven switches 61 and seven constant current sources 62. One switch is turned on or off in accordance with bit b1, two switches are turned on or off in unison in accordance with bit b2, and four switches are turned on or off in unison in accordance with bit b3.

Each switch 61 may be a single-pole single-throw switch or a single-pole double-throw switch.

Fig. 4 is a circuit diagram explaining an operation of the control voltage source circuit 11 of Fig. 1. In Fig. 4, the horizontal axis indicates codes made of the bits b1 to b3 of the control signal k, and the vertical axis indicates the control voltage Vc(k) corresponding to each of the codes. When all the switches 61 are turned off (i.e., the control signal k is "000"), the control voltage Vc(k) is equal to a power supply voltage Vcc. Per turning on one switch 61, the control voltage Vc(k) is reduced by I x R0 from the power supply voltage Vcc. When all the switches 61 are turned on (i.e., the control signal k is "111"), the control voltage Vc(k) is equal to Vcc - 7 x I x R0.

In the present disclosure, the control voltage Vc(k) may also be simply referred to as the control voltage Vc, for simplicity.

Again referring to Fig. 2, the reference voltage source circuit 12 is provided with resistors R21 to R28 and the plurality of 2M taps. Fig. 2 shows a case of M = 3. The resistors R21 and R25 to R28 are first voltage-divider resistors connected in series between a terminal of the positive power supply voltage Vcc and a terminal of the negative power supply voltage Vee, the first voltage-divider resistors generating the reference voltages Vr2, Vr4, and Vr6 from the power supply voltage. The reference voltages Vr2, Vr4, and Vr6 appear at M taps among the resistors R25 to R28. The resistors R21 to R24 and R28 are second voltage-divider resistors connected in series between the terminal of the positive power supply voltage Vcc and the terminal of the negative power supply voltage Vee, the second voltage-divider resistors generating the reference voltages Vr1, Vr3, and Vr5 from the power supply voltage. The reference voltages Vr1, Vr3, and Vr5 appear at M taps among the resistors R21 to R24. Resistances of the resistors R24 and R25 are set equal to each other. In addition, the resistances of the resistors R22, R23, R26, and R27 are set equal to each other, and twice the resistance of the resistor R24 or R25. By setting the resistances of the resistors R22 to R27 in such a manner, it is possible to generate the reference voltages Vr1 to Vr6 for simultaneously generating a sine wave and a cosine wave.

In the present disclosure, the reference voltages Vr1 to Vr6 may also be simply referred to as a reference voltage Vr, for simplicity.

The folding circuit 13 is provided with differential amplifiers 31 to 33, and resistors R31 and R32. The differential amplifier 31 compares the control voltage Vc with the reference voltage Vr2 to generate a first differential output signal. The differential amplifier 32 compares the control voltage Vc with the reference voltage Vr4, which is higher than the reference voltage Vr2, to generate a second differential output signal. The differential amplifier 33 compares the control voltage Vc with the reference voltage Vr6, which is higher than the reference voltage Vr4, to generate a third differential output signal. Output terminals of the differential amplifiers 31 to 33 are connected to the terminal of the power supply voltage Vcc via the resistors R31 and R32. The first output signal Vsin(k) is a sum of differential output signals of the differential amplifiers 31 and 33, and an inverted signal of a differential output signal of the differential amplifier 32.

The folding circuit 14 is provided with differential amplifiers 41 to 43, and resistors R41 and R42. The differential amplifier 41 compares the control voltage Vc with the reference voltage Vr1 to generate a fourth differential output signal. The differential amplifier 42 compares the control voltage Vc with the reference voltage Vr3, which is higher than the reference voltage Vr1, to generate a fifth differential output signal. The differential amplifier 43 compares the control voltage Vc with the reference voltage Vr5, which is higher than the reference voltage Vr3, to generate a sixth differential output signal. Output terminals of the differential amplifiers 41 to 43 are connected to the terminal of the power supply voltage Vcc via the resistors R41 and R42. The second output signal Vcos(k) is a sum of differential output signals of the differential amplifiers 41 and 43, and an inverted signal of a differential output signal of the differential amplifier 42.

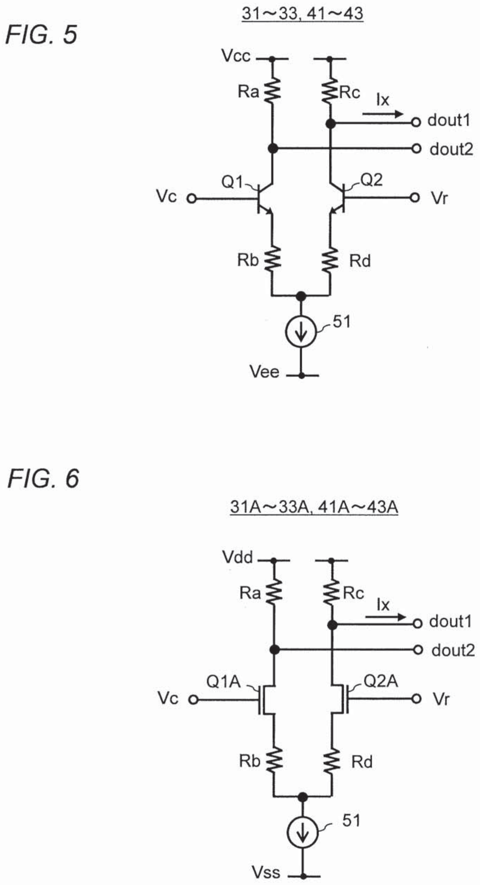

Fig. 5 is a circuit diagram showing an exemplary configuration of the differential amplifiers 31 to 33 and 41 to 43 of Fig. 2. Each of the differential amplifiers 31 to 33 and 41 to 43 is provided with a pair of bipolar transistors Q1 and Q2, a constant current source 51, and resistors Ra to Rd. The control voltage Vc is applied to a base of the bipolar transistor Q1, and the reference voltage Vr (one of the reference voltages Vr1 to Vr6) is applied to a base of the bipolar transistor Q2. An output current Ix flows through the output terminal dout1 and dout2 in accordance with a voltage difference between the control voltage Vc and the reference voltage Vr.

Fig. 6 is a circuit diagram showing another exemplary configuration of the differential amplifiers 31 to 33 and 41 to 43 of Fig. 2. The folding circuits 13 and 14 may be provided with the differential amplifiers 31A to 33A and 41A to 43A of Fig. 6, instead of the differential amplifiers 31 to 33 and 41 to 43 of Fig. 5. Each of the differential amplifiers 31A to 33A and 41A to 43A is provided with a pair of field effect transistors Q1A and Q2A, instead of the bipolar transistors Q1 and Q2 of Fig. 5.

The differential amplifiers may have emitter feedback resistors, or may include a Darlington connection. Furthermore, the folding circuits 13 and 14 may be provided with cascoded differential amplifiers, or may be provided with two-stage cascaded differential amplifiers.

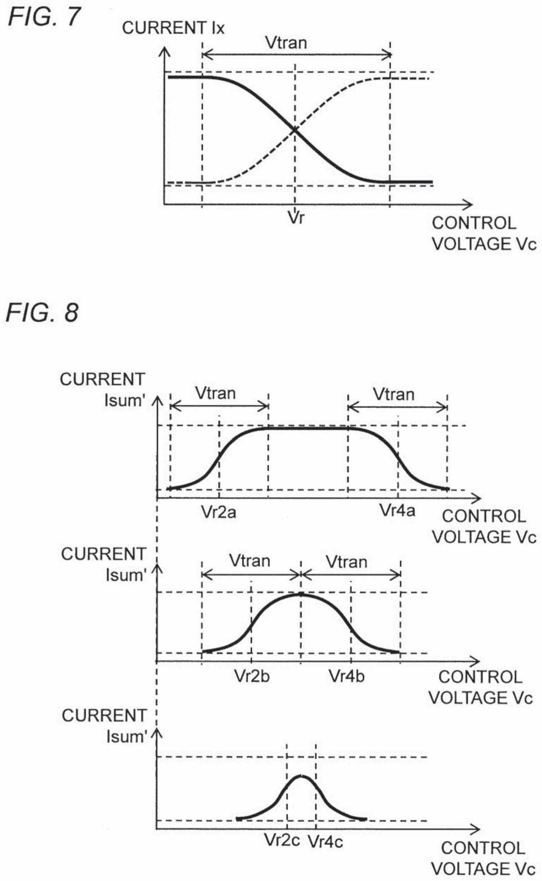

Fig. 7 is a graph schematically showing operation characteristics of each of the differential amplifiers 31 to 33 and 41 to 43 of Fig. 2. The output current Ix of each of the differential amplifiers 31 to 33 and 41 to 43 approximately varies with transmission characteristics of a hyperbolic sine function tanh(Vc) with respect to the control voltage Vc (solid line), or transmission characteristics of an inverted signal thereof (broken line). When the control voltage Vc is within a predetermined voltage range Vtran centered on the reference voltage Vr, the output current Ix varies in accordance with the control voltage Vc. On the other hand, when the control voltage Vc is outside the voltage range Vtran, the output current Ix does not substantially change even when the control voltage Vc changes.

Fig. 8 is a graph schematically showing changes in operation characteristics in cases where different reference voltages Vr2 and Vr4 are set for a pair of the differential amplifiers 31 and 32 of Fig. 2. The top, the middle, and the bottom of Fig. 8 show the current Isum', that is a sum of the output currents of the differential amplifiers 31 and 32, with respect to the change in the control voltage Vc. The top of Fig. 8 shows a case where the reference voltages Vr2 and Vr4 having a large difference (shown as reference voltages Vr2a and Vr4a) are set. The bottom of Fig. 8 shows a case where the reference voltages Vr2 and Vr4 having a small difference (shown as reference voltages Vr2c and Vr4c) are set. The middle of Fig. 8 shows a case where the reference voltages Vr2 and Vr4 having an intermediate difference (shown as reference voltages Vr2b and Vr4b) are set. By combining the differential amplifiers 31 and 32 each having characteristics of a hyperbolic sine function, the current Isum' varies with characteristics in which the two hyperbolic sine functions are connected, with respect to the control voltage Vc. In the cases of the top and the bottom of Fig. 8, the current Isum' significantly deviates from a sine wave waveform. On the other hand, in the case of the middle of Fig. 8, it can be seen that the current Isum' can be well approximated to a sine wave waveform by appropriately setting a difference between the reference voltages Vr2 and Vr4.

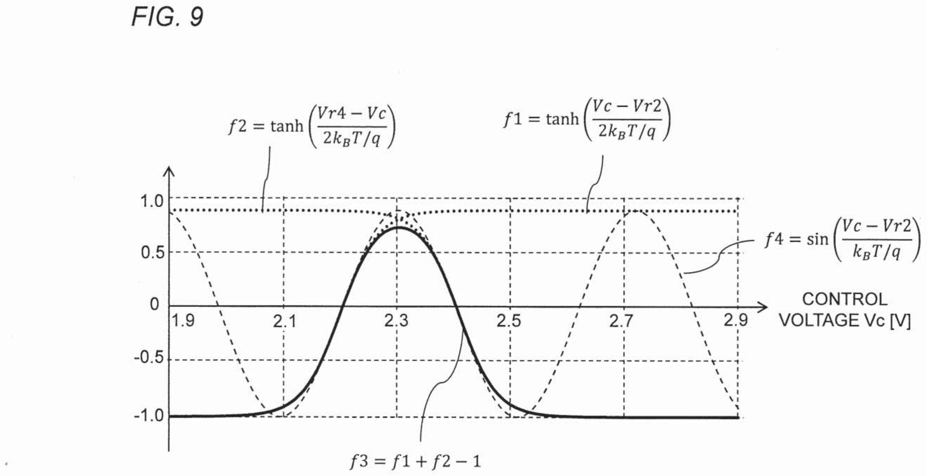

Fig. 9 is a graph explaining that the pair of differential amplifiers 31 and 32 of Fig. 2 can generate a signal having a waveform similar to a sine wave. The equation f1 represents transmission characteristics of the differential amplifier 31, and the equation f2 represents transmission characteristics of the differential amplifier 32. The equation f3 represents combined transmission characteristics of the differential amplifiers 31 and 32 adjacent to each other. The equation f4 represents an ideal sine wave. "$k_B$" represents a Boltzmann constant, "T" represents a temperature, and "q" represents an elementary charge. According to the plots of the equations f1 to f4, it is understood that the combined transmission characteristics of the differential amplifiers 31 and 32 can be well approximated to a sine wave waveform in a range of the control voltage Vc = 2.1 to 2.5.

Similarly, by appropriately setting a difference between the reference voltages Vr4 and Vr6, a sum of the output currents of the differential amplifiers 32 and 33 can also be well approximated to a sine wave waveform. In addition, by appropriately setting a difference between the reference voltages Vr1 and Vr3, a sum of the output currents of the differential amplifiers 41 and 42 can also be well approximated to a sine wave waveform. In addition, by appropriately setting a difference between the reference voltages Vr3 and Vr5, a sum of the output currents of the differential amplifiers 42 and 43 can also be well approximated to a sine wave waveform.

Each of the folding circuits 13 and 14 is an analog circuit in which an output voltage repeats increase and decrease a plurality of times in accordance with an increase or decrease of the input voltage.

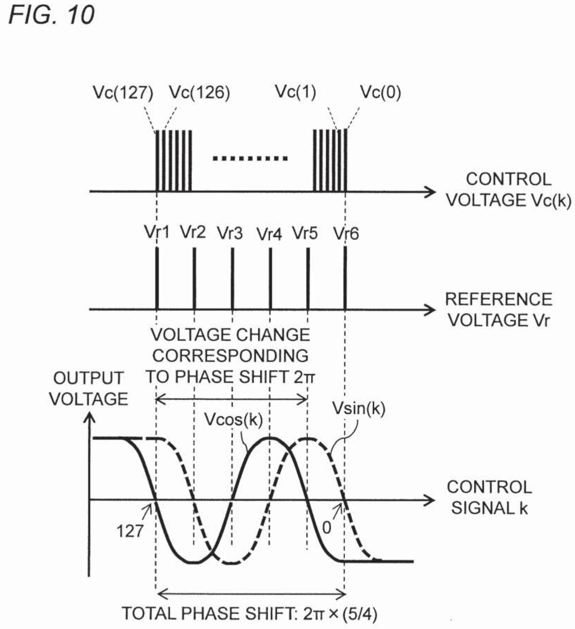

Fig. 10 is a diagram explaining a relationship among the control voltage Vc(k), the reference voltages Vr, and the output signals Vsin(k) and Vcos(k) of Fig. 1. The top of Fig. 10 shows possible voltage values Vc(0), ... , Vc(127) of the control voltage Vc(k). The middle of Fig. 10 shows possible voltage values Vr1 to Vr6 of the reference voltage Vr. The bottom of Fig. 10 shows that magnitudes of the output signals Vsin(k) and Vcos(k) vary in accordance with the control voltage Vc(k). Fig. 10 shows a case of N = 128.

A total phase shift of the phase shifter 1 is ((M - 1)/4)·$2\pi$ radians. For example, when the control voltage Vc(k) varies across a voltage difference of Vr5 - Vr1 (alternatively, across a voltage difference of Vr6 - Vr2), the quadrature modulation circuit 20 produces a phase shift of $2\pi$.

An upper limit and a lower limit of the control voltage Vc(k) may be set identical to an upper limit and a lower limit of the reference voltage Vr, respectively (Vc(127) = Vr1 and Vc(0) = Vr6). In this case, when selecting the k-th voltage value of the control voltage source circuit 11, the phase shift of the phase shifter 1 is expressed as follows.

[Mathematical Expression 4]

$$\frac{k}{N} \cdot \frac{M-1}{4} 2\pi = k\frac{M-1}{2N}\pi$$

As described above, the parameter M determines the total phase shift of the phase shifter 1. When a wide phase shift is required, a large M is set when designing the phase shifter 1. In addition, the parameter N determines a resolution with which the control signal k can be set. When fine resolution is required, a large N is set when designing the phase shifter 1.

[ADVANTAGEOUS EFFECTS OF FIRST EMBODIMENT]

As described above, the signal generation circuit 10 is provided with: the two folding circuits 13 and 14; and the control voltage source circuit 11 and the reference voltage source circuit 12 that respectively generate the control voltage Vc and the reference voltage Vr used in the folding circuits 13 and 14. The folding circuits 13 and 14 generate the output signals Vsin(k) and Vcos(k) having signal levels corresponding to predetermined phases of the sine wave and cosine wave, the phases varying in proportion to the value of the control signal k. The output signals Vsin(k) and Vcos(k) are applied as DC coefficients to the two multipliers 22 and 23 of the quadrature modulation circuit 20. As a result, a phase of the original frequency signal to be inputted to the quadrature modulation circuit 20 is shifted by a phase proportional to the control signal k, and outputted as the phase-shifted frequency signal. According to the present embodiment, it is possible to provide the signal generation circuit 10 and the phase shifter 1 having a smaller circuit size and a smaller power consumption than the prior art, being operable at a higher speed than the prior art, having tolerance to PVT variations, and having linear control characteristics with respect to a control signal.

The phase shifter 1 provided with the signal generation circuit 10 according to the embodiment has the following advantages, as compared with the case of referring to data stored in a storage device in advance as in Patent Document 1 (for example, the case of using a lookup table).

**[0059]** - It is possible to implement a control circuit with a much smaller number of components than the prior art, and design the circuit easily and at low cost. In addition, it is possible to reduce a chip size, and achieve a low-cost phase shifter.

- In a case where the phase shifter 1 is disposed in a front-end circuit of a wireless terminal apparatus, both the signal generation circuit 10 and the quadrature modulation circuit 20 are manufactured as a high-frequency integrated circuit, and therefore, it is possible to implement highly-matched analog circuits with a small number of components. It should be noted that there is a technical difficulty in implementing a digital circuit on a high-frequency integrated circuit.
- In a case of implementing massive multiple-input and multiple-output (massive MIMO), it is necessary to increase the number of antenna elements of an array antenna apparatus. However, in the case of using a high-frequency band, such as a millimeter wave, the number of antenna elements of the array antenna apparatus can not be increased from a viewpoint of power consumption, and therefore, it is considered to use a method of transmitting and receiving while changing beam patterns at short time intervals (time division multiple access massive MIMO or virtual massive MIMO). In the case of using such a method, it is necessary to control phase shifters at high speed, and it is necessary to operate signal generation circuits at high speed. Therefore, implementing the signal generation circuit 10 with analog circuits having a small number of components is particularly useful in terms of power consumption.

Since the control voltage source circuit 11 is configured as the current-output digital-to-analog converter, the control voltage source circuit 11 operates in a current mode. Therefore, the control voltage source circuit 11 can generate the control voltage Vc(k) at a higher speed as compared with a case in which the circuit is configured as a resistor ladder. In addition, an output impedance of the control voltage source circuit 11 can be reduced by reducing the resistance of the resistor R0, and in this case, the control voltage source circuit 11 can operate at a more higher speed. In addition, since the control voltage source circuit 11 is configured as the current-output digital-to-analog converter, the control voltage source circuit 11 can accurately generate the control voltage Vc(k). In addition, since the control voltage source circuit 11 is configured as the current-output digital-to-analog converter, it is possible to charge parasitic capacitances of the subsequent folding circuits 13 and 14. Accordingly, it is possible to implement the phase shifter 1 capable of switching at a high speed, and being accurate.

Since the control voltage source circuit 11 can be implemented by the plurality of switches 61 having the same characteristics with each other, and the plurality of constant current sources 62 having the same characteristics with each other, integrating them can reduce variations in manufacturing process. In addition, since the reference voltage source circuit 12 can be implemented by a plurality of resistors having the same resistance with each other, or by a plurality of resistors having a certain resistance or a resistance twice thereof, integrating them can reduce variations in manufacturing process.

As described above, the present circuit has high tolerance to variations in a manufacturing process (P), a power supply voltage (V), and a temperature (T). Having tolerance to PVT variations, it is possible to maintain the same performance in various environments.

The differential amplifier has a high common mode rejection ratio (CMRR). Therefore, even if PVT variations occur, the variations are cancelled when the same variations are applied to two input signals for the differential amplifier. Thus, according to the first embodiment, it is possible to significantly improve tolerance to PVT variations.

In a case of using an analog control voltage inputted externally, instead of using the control voltage source circuit 11 to generate the control voltage Vc as in the present embodiment, there is an issue of low tolerance to PVT variations, since the control voltage is generated by a mechanism different from the folding circuits within the phase shifter. On the other hand, according to the present embodiment, for example, by using the control voltage source circuit 11 and the reference voltage source circuit 12 that are integrated with each other, it is possible to further improve the tolerance to PVT variations.

According to the first embodiment, the control voltage source circuit 11 generates the one control voltage Vc(k), and the reference voltage source circuit 12 generates the six reference voltages Vr1 to Vr6. The folding circuits 14 is supplied with the reference voltages Vr1, Vr3, and Vr5, and the folding circuits 13 is supplied with the different reference voltages Vr2, Vr4, and Vr6, and thus, a phase difference occurs between the output signals Vsin(k) and Vcos(k).

[SECOND EMBODIMENT]

According to the first embodiment, the two folding circuits are supplied with the common control voltage, and supplied with the reference voltages different from each other. On the other hand, according to a second embodiment, two folding circuits are supplied with common reference voltages, and supplied with control voltages different from each other.

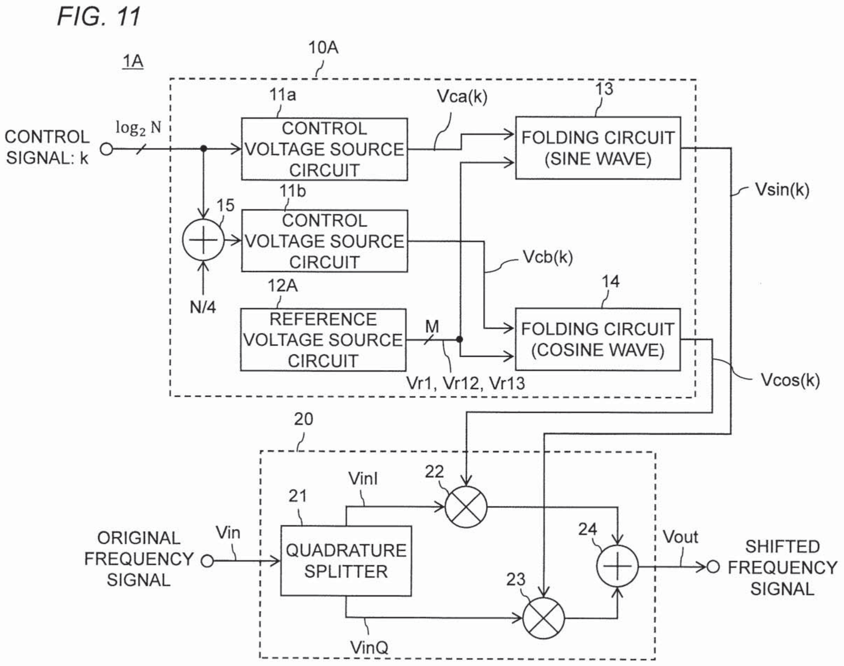

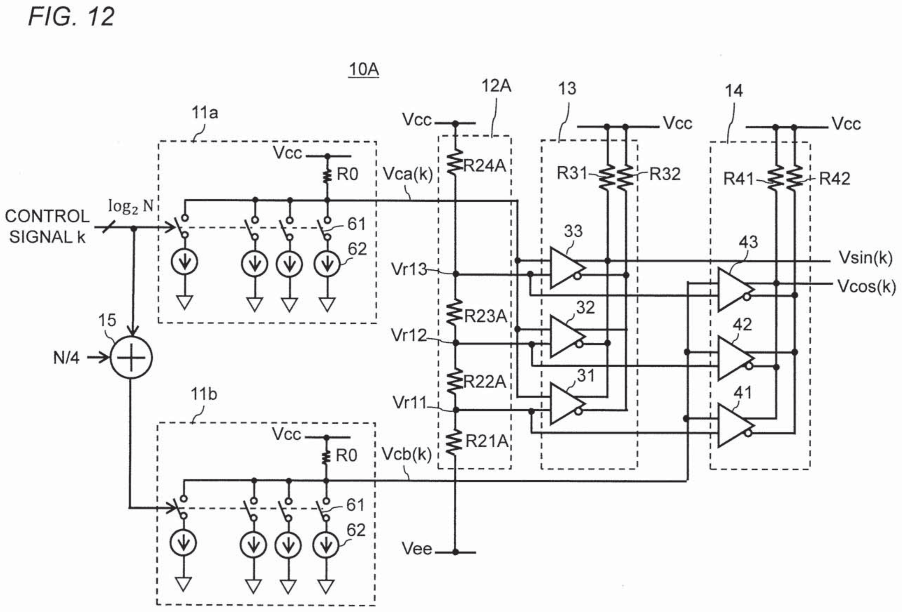

Fig. 11 is a block diagram showing a configuration of a phase shifter 1A provided with a signal generation circuit 10A according to the second embodiment. Fig. 12 is a circuit diagram showing a configuration of the signal generation circuit 10A of Fig. 11. The signal generation circuit 10A is provided with control voltage source circuits 11a and 11b, a reference voltage source circuit 12A, folding circuits 13 and 14, and an adder 15.

Each of the control voltage source circuits 11a and 11b are configured in a manner similar to that of the control voltage source circuit 11 of Fig. 2. It should be noted that the control voltage source circuit 11a is supplied with the control signal k itself, and the control voltage source circuit 11b is supplied with a signal which is a sum of the control signal k and a predetermined value, e.g., N/4, the sum being produced by the adder 15. The control voltage source circuit 11a generates a control voltage Vca(k) in accordance with the control signal k, and supplies the control voltage Vca(k) to the differential amplifiers 31 to 33 of the folding circuit 13. The control voltage source circuit 11b generates a control voltage Vcb(k) in accordance with the control signal k + N/4, and supplies the control voltage Vcb(k) to the differential amplifiers 41 to 43 of the folding circuit 14.

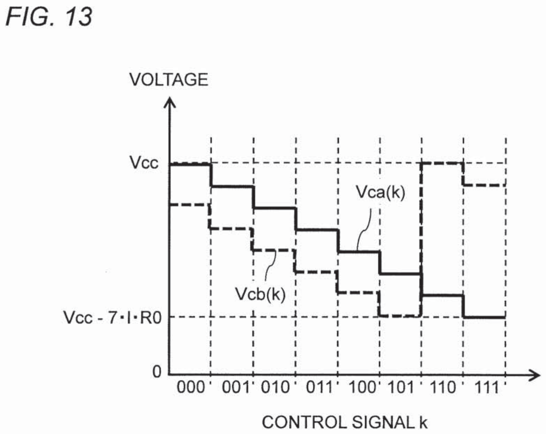

Fig. 13 is a diagram explaining operations of the control voltage source circuits 11a and 11b of Fig. 11. Fig. 13 shows a case of N = 8, in which each of the control voltage source circuits 11a and 11b is provided with the seven switches 61 and the seven constant current sources 62, in a manner similar to that of Figs. 3 and 4. In this case, the adder 15 adds N/4 = 8/4 = 2 to the control signal k, and supplies the sum to the control voltage source circuit 11b. Therefore, when the control voltage source circuit 11a is supplied with the control signal k = 0, 1, ..., 7, the control voltage source circuit 11b is supplied with the corresponding control signal k+2 = 2, 3, ..., 9. When the control signal supplied to the control voltage source circuit 11b is equal to or more than N, an overflow occurs and N is subtracted from the control signal. Therefore, in the example of Fig. 13, when the control voltage source circuit 11a generates the control voltage Vca(k) in accordance with the control signal $k = 0, 1, ..., 7$, the control voltage source circuit 11b generates the control voltage Vcb(k) in accordance with the corresponding control signal $k = 2, 3, ..., 7, 0, 1$. Since the control voltage source circuits 11a and 11b have the same configuration with each other, the control voltages Vca(k) and Vcb(k) having a voltage difference $2 \times I \times R0$ that is constant modulo a difference $7 \times I \times R0$ between a maximum and a minimum of the control voltage Vca(k).

$$Vca(k) - Vcb(k) = 2 \times I \times R0 \ (mod \ 7 \times I \times R0)$$

Again referring to Figs. 11 and 12, the reference voltage source circuit 12A is provided with resistors R21A to R24A and a plurality of M taps. Fig. 12 shows a case of $M = 3$. The resistors R21A to R24A are voltage-divider resistors connected in series between a terminal of the positive power supply voltage Vcc and a terminal of the negative power supply voltage Vee, the voltage-divider resistors generating the reference voltages Vr11, Vr12, and Vr13 from the power supply voltage. The reference voltages Vr11, Vr12, and Vr13 appear at the M taps among the resistors R21A to R24A. Resistances of the resistors R22A and R23A are set equal to each other. The reference voltage Vr11 is supplied to the differential amplifiers 31 and 41, the reference voltage Vr12 is supplied to the differential amplifiers 33 and 43, and the reference voltage Vr13 is supplied to the differential amplifiers 33 and 43.

The folding circuits 13 and 14 of Fig. 11 are configured in a manner similar to that of the folding circuits 13 and 14 of Fig. 2.

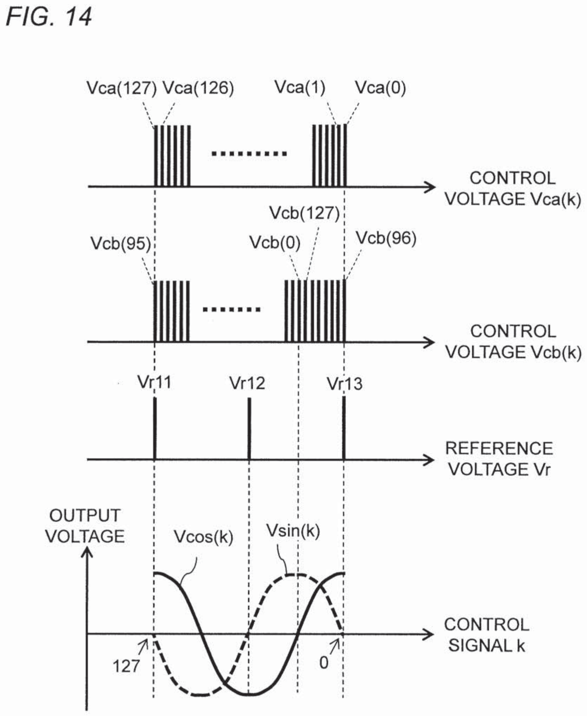

Fig. 14 is a diagram explaining a relationship among control voltages Vca(k) and Vcb(k), reference voltages Vr, and output signals Vsin(k) and Vcos(k) of Fig. 11. The first row of Fig. 14 shows possible voltage values Vca(0), ... , Vca(127) of the control voltage Vca(k). The second row of Fig. 14 shows possible voltage values Vcb(0), ... , Veb(127) of the control voltage Vcb(k). The third row of Fig. 14 shows possible voltage values Vr11 to Vr13 of the reference voltage Vr. The fourth row of Fig. 14 shows that magnitudes of the output signals Vsin(k) and Vcos(k) vary in accordance with the control voltages Vca(k) and Vcb(k). Fig. 14 shows a case of $N = 128$.

Referring to Fig. 14, when the control signal k varies from the minimum 0 to the maximum 127, the control voltages Vca(k) and Vcb(k) vary from the minimum to the maximum, and accordingly, the phases of the output signals Vsin(k) and Vcos(k) vary across $2\pi$. The value of N/4 to be added to the control signal k by the adder 15 corresponds to a phase difference of $\pi/2$ between the output signals Vsin(k) and Vcos(k). According to the second embodiment, since the folding circuits 13 and 14 are supplied with the different control signals Vca(k) and Vcb(k), respectively, the folding circuits 13 and 14 can operate using the common reference voltages Vr11, Vr12, and Vr13.

According to the first embodiment, the control voltage source circuit 11 is connected with the six differential amplifiers 31 to 33, 41 to 43. On the other hand, according to the second embodiment, the control voltage source circuit 11a is connected with the three differential amplifiers 31 to 33, and the control voltage source circuit 11b is connected with the three differential amplifiers 41 to 43. Therefore, according to the second embodiment, the load applied to each of the control voltage source circuits 11a and 11b is reduced than that of the control voltage source circuit 11 of the first embodiment, and as a result, the control voltage source circuits 11a and 11b can operate faster than the control voltage source circuit 11.

The signal generation circuit 10 of the first embodiment operates using the six reference voltages Vr1 to Vr6. On the other hand, the signal generation circuit 10A of the second embodiment can operate using three reference voltages Vr11 to Vr13. Therefore, according to the second embodiment, the configuration of the reference voltage source circuit 12A can be simplified as compared with the reference voltage source circuit 12 of the first embodiment.

According to the second embodiment, the control voltage source circuits 11a and 11b generate the control voltages Vca(k) and Vcb(k), respectively, and the reference voltage source circuit 12A generates the three reference voltages Vr11 to Vr13. The folding circuits 13 is supplied with the control voltage Vca(k), and the folding circuits 14 is supplied with the different control voltage Vcb(k), and thus, a phase difference occurs between the output signals Vsin(k) and Vcos(k).

[THIRD EMBODIMENT]

According to a second embodiment, the two control voltage source circuits are supplied with the different control signals to generate the different control voltages. On the other hand, according to a third embodiment, a control voltage generated by one of two control voltage source circuits is shifted to generate different control voltages.

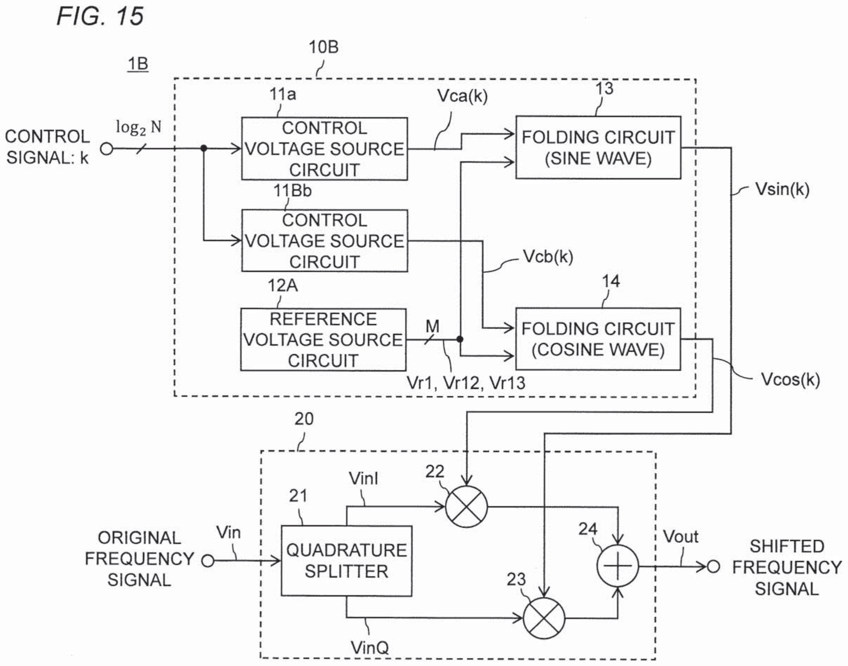

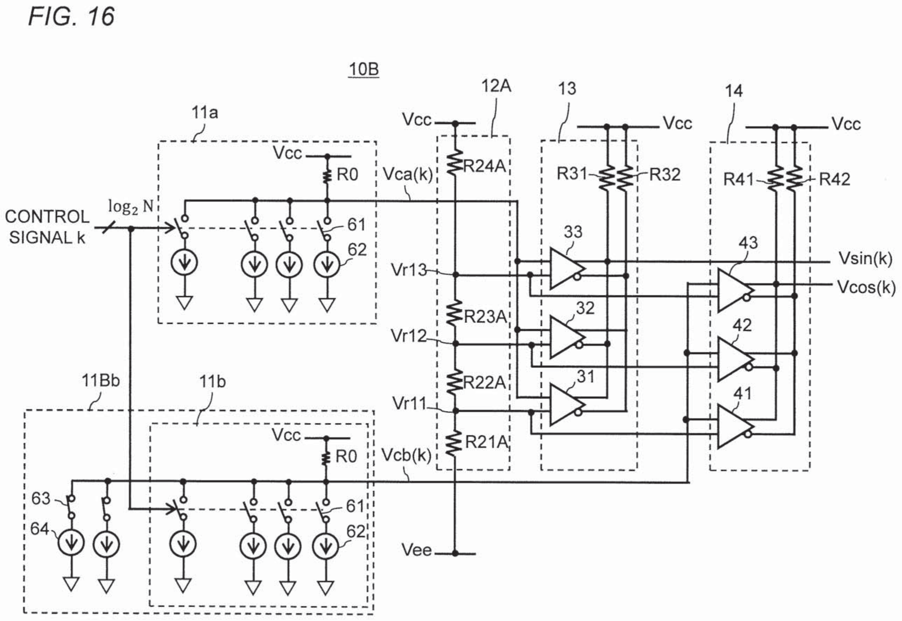

Fig. 15 is a block diagram showing a configuration of a phase shifter 1B provided with a signal generation circuit 10B according to the third embodiment. Fig. 16 is a circuit diagram showing a configuration of the signal generation circuit 10B of Fig. 15. The signal generation circuit 10B is provided with control voltage source circuits 11a and 11Bb, a reference voltage source circuit 12A, and folding circuits 13 and 14.

The control voltage source circuit 11a is configured in a manner similar to that of the control voltage source circuit 11 of Fig. 2. The control voltage source circuit 11Bb is provided with a control voltage source circuit 11b configured in a

11

EP 4 657 754 A1

manner similar to that of the control voltage source circuit 11 of Fig. 2, and further provided with one or more switches 63 and one or more constant current sources 64. The switches 63 have the same characteristics as those of the switches 61 of the control voltage source circuits 11a and 11b. In addition, the constant current sources 64 have the same characteristics as those of the constant current sources 62 of the control voltage source circuits 11a and 11b, and each generates a predetermined current I. The control voltage source circuits 11a and 11b are provided with the same control signal k. The control voltage source circuit 11a generates a control voltage Vca(k) in accordance with the control signal k, and supplies the control voltage Vca(k) to the differential amplifiers 31 to 33 of the folding circuit 13. The control voltage source circuit 11Bb generates a control voltage Vcb(k) in accordance with the control signal k, and supplies the control voltage Vcb(k) to the differential amplifiers 41 to 43 of the folding circuit 14. In the control voltage source circuit 11Bb, the switches 63 are constantly turned on, and therefore, the constant current sources 64 constantly generate a current corresponding to a voltage difference between the control voltages Vca(k) and Vcb(k).

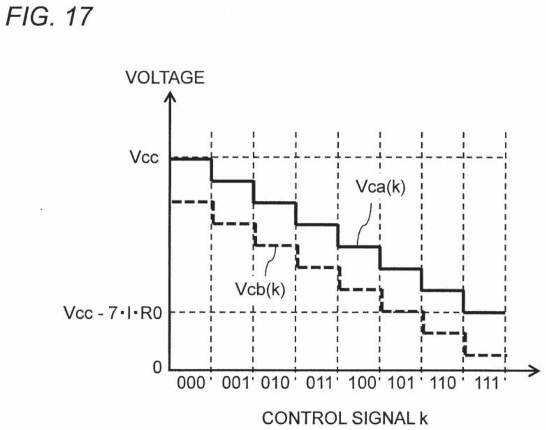

Fig. 17 is a diagram explaining operations of the control voltage source circuits 11a and 11Bb of Fig. 15. Fig. 17 shows a case of N = 8, in which each of the control voltage source circuits 11a and 11Bb is provided with the seven switches 61 and the seven constant current sources 62, in a manner similar to that of Figs. 3 and 4. The control voltage source circuit 11Bb is further provided with the two switches 63 and the two constant current sources 64. Since the switches 63 are constantly turned on as described above, there is a a constant voltage different 2 x I x R0 between the control voltages Vca(k) and Vcb(k) due to a current 2 x I generated by the constant current sources 64.

The reference voltage source circuit 12A and the folding circuits 13 and 14 of Fig. 15 are configured in a manner similar to that of the corresponding components of Fig. 11.

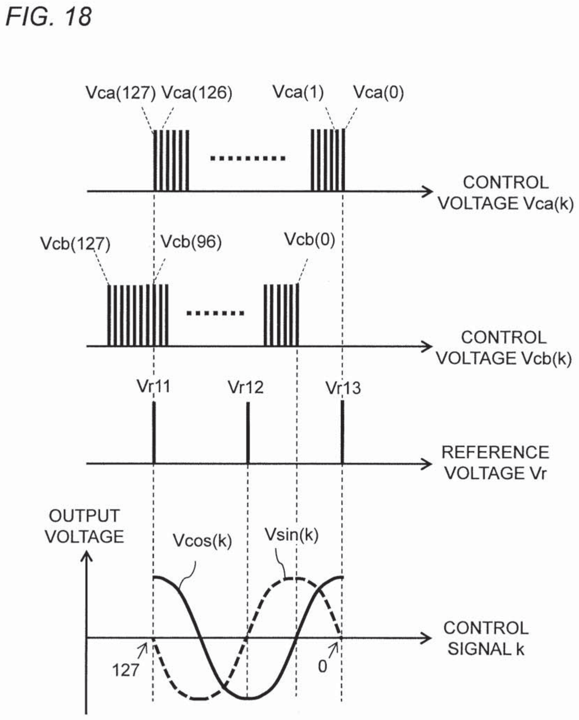

Fig. 18 is a diagram explaining a relationship among control voltages Vca(k) and Vcb(k), reference voltages Vr, and output signals Vsin(k) and Vcos(k) of Fig. 15. The first row of Fig. 18 shows possible voltage values Vca(0), ... , Vca(127) of the control voltage Vca(k). The second row of Fig. 18 shows possible voltage values Vcb(0), ... , Vcb(127) of the control voltage Vcb(k). The third row of Fig. 18 shows possible voltage values Vr11 to Vr13 of the reference voltage Vr. The fourth row of Fig. 18 shows that magnitudes of the output signals Vsin(k) and Vcos(k) vary in accordance with the control voltages Vca(k) and Vcb(k). Fig. 18 shows a case of N = 128.

Referring to Fig. 18, when the control signal k varies from the minimum 0 to the maximum 127, the control voltages Vca(k) and Vcb(k) vary from the minimum to the maximum, and accordingly, the phases of the output signals Vsin(k) and Vcos(k) vary across $2\pi$. The voltage difference between the control voltages Vca(k) and Vcb(k), which is due to the current generated by the constant current sources 64, correspond to a phase difference of $\pi/2$ between the output signals Vsin(k) and Vcos(k). Therefore, the numbers of the switches 63 and the constant current sources 64 are determined so that the output signals Vsin(k) and Vcos(k) have a desired phase difference. In the example of Fig. 18, the control voltage source circuit 11Bb is provided with 32 switches 63 and 32 constant current sources 64. According to the third embodiment, since the folding circuits 13 and 14 are supplied with the different control signals Vca(k) and Vcb(k), respectively, the folding circuits 13 and 14 can operate using the common reference voltages Vr11, Vr12, and Vr13.

According to the third embodiment, in a manner similar to that of the second embodiment, the load applied to each of the control voltage source circuits 11a and 11Bb is reduced than that of the control voltage source circuit 11 of the first embodiment, and as a result, the control voltage source circuits 11a and 11Bb can operate faster than the control voltage source circuit 11. In addition, according to the third embodiment, in a manner similar to that of the second embodiment, the configuration of the reference voltage source circuit 12A can be simplified as compared with the reference voltage source circuit 12 of the first embodiment.

According to the third embodiment, the control voltage source circuits 11a and 11Bb generate the control voltages Vca(k) and Vcb(k), respectively, and the reference voltage source circuit 12A generates the three reference voltages Vr11 to Vr13. The folding circuits 13 is supplied with the control voltage Vca(k), and the folding circuits 14 is supplied with the different control voltage Vcb(k), and thus, a phase difference occurs between the output signals Vsin(k) and Vcos(k).

[FOURTH EMBODIMENT]

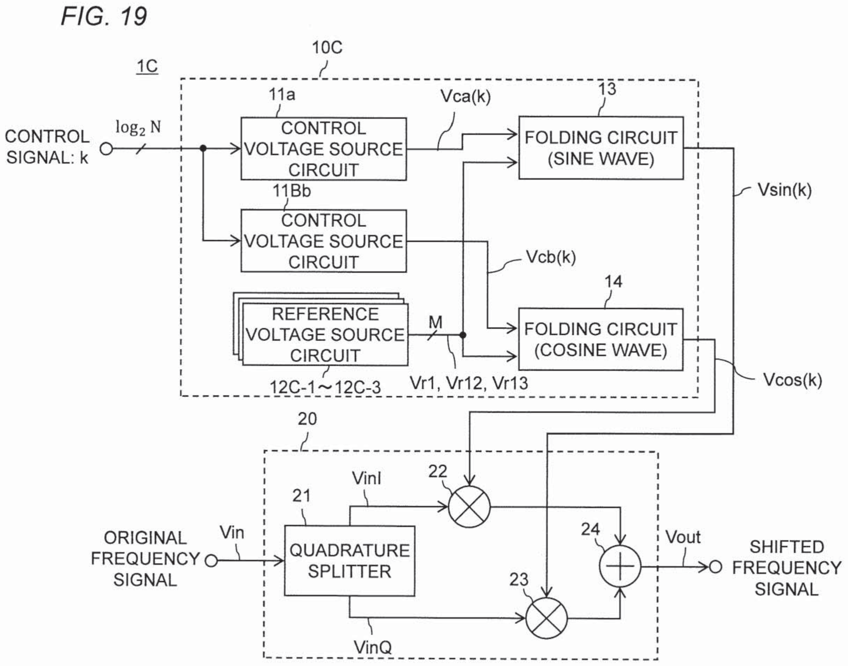

Fig. 19 is a block diagram showing a configuration of a phase shifter 1C provided with a signal generation circuit 10C according to a fourth embodiment. The signal generation circuit 10C is provided with reference voltage source circuits 12C1 to 12C-3, instead of the reference voltage source circuit 12A of Fig. 15.

The reference voltage source circuits 12C1 to 12C-3 generate reference voltages Vr11 to Vr13, respectively. The reference voltage source circuits 12C1 to 12C-3 are replica circuits of the control voltage source circuits 11a and 11Bb, such that each of the reference voltage source circuits 12C1 to 12C-3 has components and a layout at least partially identical to components and a layout of the control voltage source circuits 11a and 11Bb.

According to the first to third embodiments, the control voltages Vc(k) or Vca(k) and Vcb(k) are generated by a current-output digital-to-analog converter, and the reference voltages Vr1 to Vr6 or Vr11 to Vr13 are generated by voltage-divider resistors. In other words, the control voltages and the reference voltages are generated by different mechanisms. As a result, variations in manufacturing process of components, such as transistors and resistors, variations in power source voltage, and variations in characteristics of components due to temperature may occur, and the output signals Vsin(k) and Vcos(k) may vary. According to the fourth embodiment, since the reference voltage source circuits 12C-1 to 12C-3, which are replica circuits of the control voltage source circuits 11a and 11Bb, generate the reference voltages Vr11 to Vr13, respectively, it is possible to improve tolerance to PVT (process, voltage, and temperature) variations.

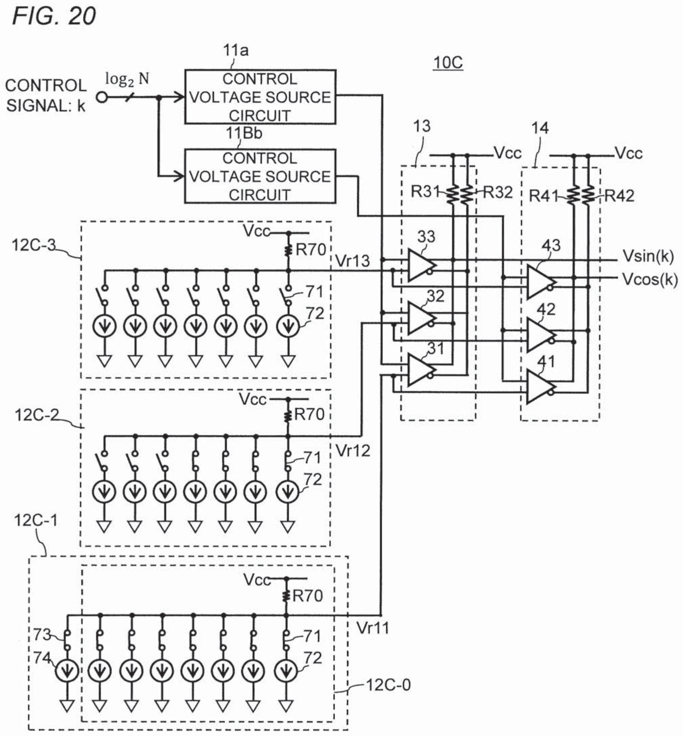

Fig. 20 is a circuit diagram showing a configuration of the signal generation circuit 10C of Fig. 19. Fig. 20 shows a case of n = 3 bits, in which each of the control voltage source circuits 11a and 11Bb is provided with the seven switches 61 and the seven constant current sources 62. Each of the reference voltage source circuits 12C-2 and 12C-3 is provided with a resistor R70, a plurality of switches 71, and a plurality of constant current sources 72. Each of the reference voltage source circuits 12C-2 and 12C-3 may be provided with seven switches 71 and seven constant current sources 72, as many as those of the control voltage source circuits 11a and 11Bb. The reference voltage source circuits 12C-1 is provided with a resistor R70, a plurality of switches 71, a plurality of constant current sources 72, an additional switch 73, and an additional constant current source 74. The reference voltage source circuits 12C-1 may be provided with seven switches 71 and seven constant current sources 72 (which are indicated as a circuit portion 12C-0), as many as those of the control voltage source circuits 11a and 11Bb. The additional switch 73 and the additional constant current source 74 have the same characteristics as those of the switches 71 and the constant current sources 72, respectively. The additional switch 73 and the additional constant current source 74 are provided in order to generate a reference voltage corresponding to a control signal k = N.

The reference voltage source circuits 12C-1 is configured in advance such that all the switches 71 and 73 are turned on, thus generating the reference voltage Vr11. The reference voltage source circuits 12C-2 is configured in advance such that four switches 71 are turned on remaining three switches are turned off, thus generating the reference voltage Vr12. The reference voltage source circuits 12C-3 is configured in advance such that all the switches 71 are turned off, thus generating the reference voltage Vr13.

Each of the circuit portion 12C-0 of the reference voltage source circuit 12C-1, the reference voltage source circuits 12C-2 and 12C-3 has components and a layout at least partially identical to components and a layout of the control voltage source circuits 11a and 11Bb. Therefore, it is possible to make the circuits less susceptible to variations in manufacturing process of components, and variations in power source voltage. In addition, the control voltage source circuits 11a and 11Bb and the reference voltage source circuits 12C-1 to 12C-3 may be arranged close to each other, in order to make the circuits less susceptible to variations in characteristics of components due to temperature.

Each of the control voltage source circuits 11a and 11Bb and the reference voltage source circuits 12C-2 and 12C-3 may be further provided with a switch 73 and a constant current source 74 in a manner similar to that of the reference voltage source circuit 12C-1, in order to improve the symmetry of the control voltage source circuits 11a and 11Bb and the reference voltage source circuits 12C-1 to 12C-3.

Since the control voltage source circuits 11a and 11Bb and the reference voltage source circuits 12C-1 to 12C-3 can be implemented by the switches 61, 63, 71, and 73 having the same characteristics with each other, and the constant current sources 62, 64, 72, and 74 having the same characteristics with each other, integrating them can reduce variations in manufacturing process. In addition, in a case where the control voltage source circuits 11a and 11Bb and the reference voltage source circuits 12C-1 to 12C-3 are implemented by the same types of circuit components, the control voltages Vca(k) and Vcb(k) and the reference voltages Vr11 to Vr13 are shifted in the same direction in accordance with variations in the power supply voltage and the temperature. Since the control voltages Vca(k) and Vcb(k) and the reference voltages Vr11 to Vr13 are supplied to the differential amplifiers 31 to 33 and 41 to 43, the voltage shifts in the same direction can be canceled due to a high common mode rejection ratio (CMRR) of the differential amplifiers.

Since all the control voltage source circuits 11a and 11Bb and the reference voltage source circuits 12C-1 to 12C-3 are configured as current-output digital-to-analog converters, it is possible to easily determine design parameters associated with voltages to be supplied to the folding circuits 13 and 14.

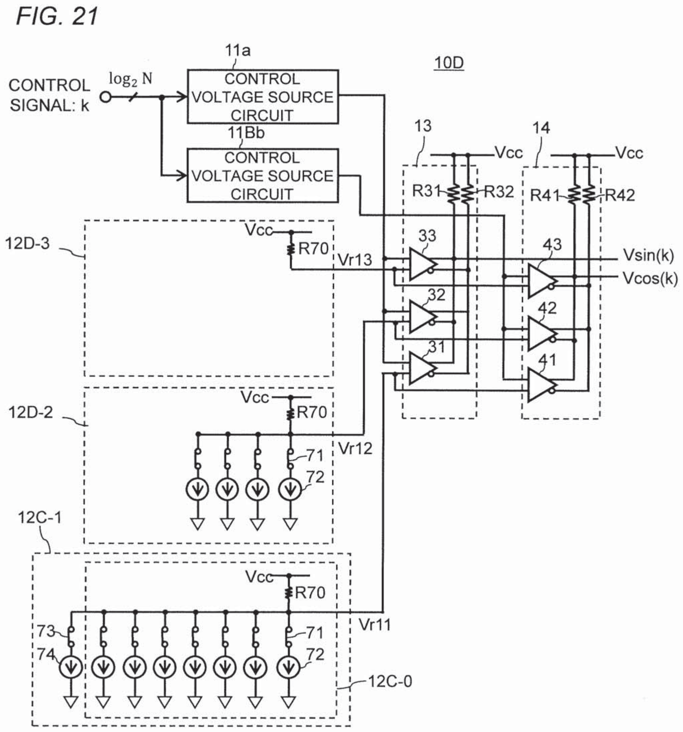

Fig. 21 is a circuit diagram showing a configuration of a signal generation circuit 10D according to a variation of the fourth embodiment. The signal generation circuit 10D may be provided with reference voltage source circuits 12D-2 and 12D-3 of Fig. 21, instead of the reference voltage source circuits 12C-2 and 12C-3 of Fig. 20. The reference voltage source circuits 12D-2 and 12D-3 are configured by removing the opened switches 71, and the constant current sources 72 connected thereto, from the reference voltage source circuits 12C-2 and 12C-3 of Fig. 20. As to components through which a current flows, each of the reference voltage source circuits 12C-1, 12D-2, and 12D-3 has components and a layout identical to components and a layout of the control voltage source circuits 11a and 11Bb. In addition, by removing, from the reference voltage source circuits, components through which no current flows, it is possible to reduce circuit size while improving tolerance to PVT variations.

According to the fourth embodiment, the control voltage source circuits 11a and 11Bb generate the control voltages Vca(k) and Vcb(k), respectively, and the reference voltage source circuits 12C-1 to 12C-3 generate the three reference voltages Vr11 to Vr13, respectively. The folding circuits 13 is supplied with the control voltage Vca(k), and the folding circuits 14 is supplied with the different control voltage Vcb(k), and thus, a phase difference occurs between the output signals Vsin(k) and Vcos(k).

[FIFTH EMBODIMENT]

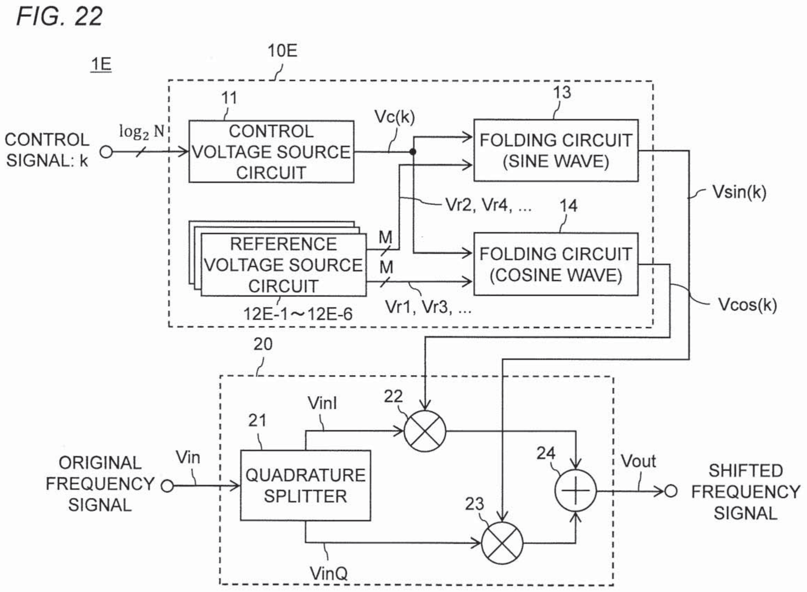

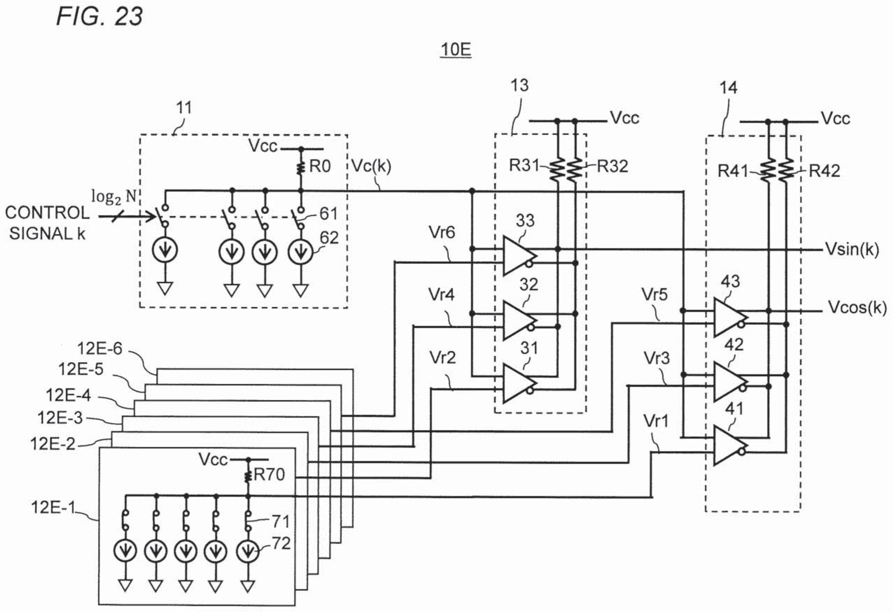

Fig. 22 is a block diagram showing a configuration of a phase shifter 1E provided with a signal generation circuit 10E according to a fifth embodiment. Fig. 23 is a circuit diagram showing a configuration of the signal generation circuit 10E of Fig. 22. The signal generation circuit 10E is provided with reference voltage source circuits 12E-1 to 12E-6, instead of the reference voltage source circuit 12 of Fig. 1.

The reference voltage source circuits 12E-1 to 12E-6 generate reference voltages Vr1 to Vr6, respectively. The reference voltage source circuits 12E-1 to 12E-6 are replica circuits of the control voltage source circuit 11, such that each of the reference voltage source circuits 12E-1 to 12E-6 has components and a layout at least partially identical to components and a layout of the control voltage source circuit 11.

Each of the reference voltage source circuits 12E-1 to 12E-6 is provided with a resistor R70, five switches 71, and five constant current sources 72. which are configured in a manner similar to that of the resistor R0, the switches 61, and the constant current sources 62 of the control voltage source circuit 11. Five series circuits, each including the switch 71 and the constant current source 72, are connected parallel to each other. Each switch 71 (or equivalently, each constant current source 72) is turned on or off in accordance with a reference voltage to be generated. The reference voltage source circuit 12E-1 is configured in advance such that the five switches 71 are turned on, thus generating the control voltage Vr1. The reference voltage source circuit 12E-2 is configured in advance such that four switches 71 are turned on, thus generating the control voltage Vr2. The reference voltage source circuit 12E-3 is configured in advance such that three switches 71 are turned on, thus generating the control voltage Vr3. The reference voltage source circuit 12E-4 is configured in advance such that two switches 71 are turned on, thus generating the control voltage Vr4. The reference voltage source circuit 12E-5 is configured in advance such that one switches 71 are turned on, thus generating the control voltage Vr5. The reference voltage source circuit 12E-6 is configured in advance such that all the five switches 71 are turned off, thus generating the control voltage Vr6.

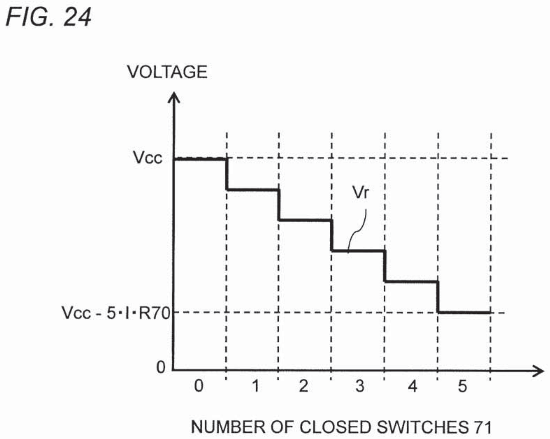

Fig. 24 is a diagram explaining operations of the reference voltage source circuits 12E-1 to 12E-6 of Fig. 22. When all the switches 71 are turned off, the reference voltage Vr is equal to a power supply voltage Vcc. Per turning on one switch 71, the reference voltage Vr is reduced by I x R0 from the power supply voltage Vcc. When all the switches 71 are turned on, the reference voltage Vr is equal to Vcc - 5 x I x R70.

Each of the reference voltage source circuits 12E-1 to 12E-6 has components and a layout at least partially identical to components and a layout of the control voltage source circuit 11. Therefore, it is possible to make the circuits less susceptible to variations in manufacturing process of components, and variations in power source voltage. In addition, the control voltage source circuit 11 and the reference voltage source circuits 12E-1 to 12E-6 may be arranged close to each other, in order to make the circuits less susceptible to variations in characteristics of components due to temperature.

Each of the reference voltage source circuits 12E-1 to 12E-6 may be provided with switches 71 and constant current sources 72 as many as the switches 61 and the constant current sources 62 of the control voltage source circuit 11 (e.g., in case of n = 3 bits, seven switches 71 and seven constant current sources 72), in order to improve the symmetry of the control voltage source circuit 11 and the reference voltage source circuits 12E-1 to 12E-6. In this case, redundant switches 71 (and equivalently, redundant constant current sources 72) of the reference voltage source circuits 12E-1 to 12E-6 are constantly turned off.

In a manner similar to that of the case as explained with reference to Fig. 21, constantly opened switches 71 and constant current sources 72 connected thereto may be removed from the reference voltage source circuits 12E-1 and 12E-6.

Since the control voltage source circuit 11 and the reference voltage source circuits 12E-1 to 12E-6 can be implemented by the switches 61 and 71 having the same characteristics with each other, and the constant current sources 62 and 72 having the same characteristics with each other, integrating them can reduce variations in manufacturing process. In addition, in a case where the control voltage source circuit 11 and the reference voltage source circuits 12E-1 to 12E-6 are implemented by the same types of circuit components, the control voltage Vc(k) and the reference voltages Vr1 to Vr6 are shifted in the same direction in accordance with variations in the power supply voltage and the temperature. Since the control voltage Vc(k) and the reference voltages Vr1 to Vr6 are supplied to the differential amplifiers 31 to 33 and 41 to 43, the voltage shifts in the same direction can be canceled due to a high common mode rejection ratio (CMRR) of the differential amplifiers.

Since all the control voltage source circuit 11 and the reference voltage source circuits 12E-1 to 12E-6 are configured as current-output digital-to-analog converters, it is possible to easily determine design parameters associated with voltages to be supplied to the folding circuits 13 and 14.

According to the fifth embodiment, the control voltage source circuit 11 generates the one control voltage Vc(k), and the reference voltage source circuits 12E-1 to 12E-6 generate the six reference voltages Vr1 to Vr6, respectively. The folding circuits 14 is supplied with the reference voltages Vr1, Vr3, and Vr5, and the folding circuits 13 is supplied with the different reference voltages Vr2, Vr4, and Vr6, and thus, a phase difference occurs between the output signals Vsin(k) and Vcos(k).

[SIXTH EMBODIMENT]

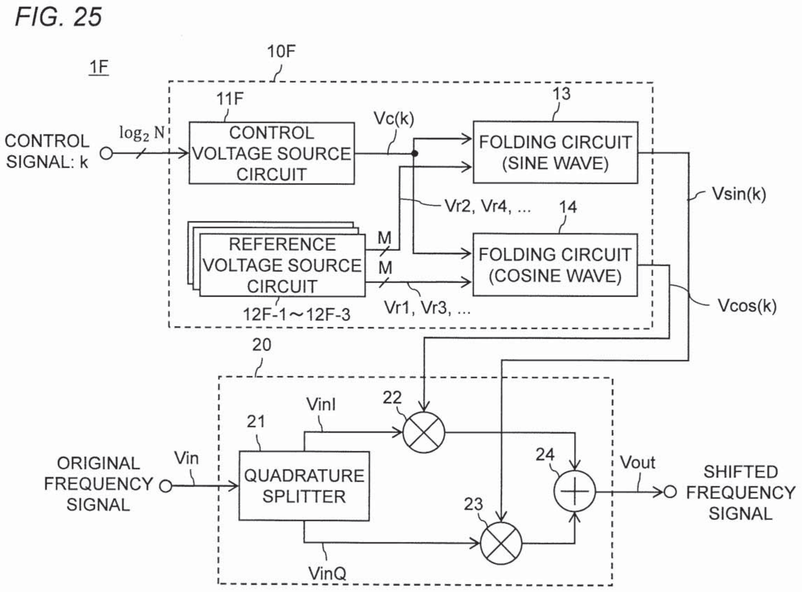

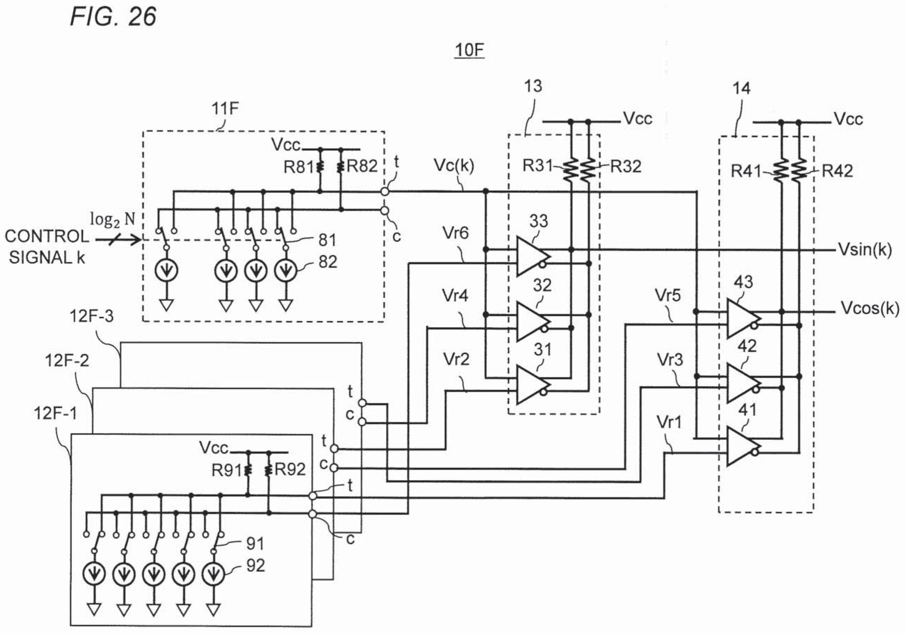

Fig. 25 is a block diagram showing a configuration of a phase shifter 1F provided with a signal generation circuit 10F according to a sixth embodiment. Fig. 26 is a circuit diagram showing a configuration of the signal generation circuit 10F of Fig. 25. The signal generation circuit 10F is provided with a control voltage source circuit 11F and a reference voltage source circuits 12F-1 to 12F-3, instead of the control voltage source circuit 11 and the reference voltage source circuit 12 of Fig. 1.

The control voltage source circuit 11F generates a control voltage Vc(k) having one of a plurality of N predetermined voltage values in accordance with an inputted control signal k, in a manner similar to that of the control voltage source circuit 11 of Fig. 1.

The reference voltage source circuit 12F-1 generates reference voltages Vr1 and Vr6, the reference voltage source circuit 12F-2 generates reference voltages Vr2 and Vr5, and the reference voltage source circuit 12F-3 generates reference voltages Vr3 and Vr4. The reference voltage source circuits 12F-1 to 12F-3 are replica circuits of the control voltage source circuit 11F, such that each of the reference voltage source circuits 12F-1 to 12F-3 has components and a layout at least partially identical to components and a layout of the control voltage source circuit 11F.

The control voltage source circuit 11 is provided with resistors R81 and R82, a plurality of switches 81, and a plurality of constant current sources 82. The resistors R81 and R82 have the same resistance of R80. Each switch 81 is a single-pole double-throw switch. Each of the constant current sources 82 is connected to one of output terminals t and c via a corresponding switch 81. The output terminals t and c are further connected to the resistors R81 and R82, respectively. Thus, a plurality of series circuits, each including the switch 81 and the constant current source 82, are connected parallel to each other. The switches 81 have the same characteristics with each other. The constant current sources 82 also have the same characteristics with each other, and each generates a predetermined current I. By controlling the switches 81 in accordance with the control signal k so that each constant current source 82 is connected one of the output terminals t and c, the currents from the constant current sources 82 connected to the output terminal t flow through the resistor R81. Equivalently, each constant current source 82 is turned on or off in accordance with the control signal k. As a result, the control voltage Vc(k) occurs, having one of the plurality of N predetermined voltage values in accordance with the control signal k. The control voltage source circuit 11 is functionally configured in a manner similar to that of a $\log_2 N$-bit current-output digital-to-analog converter.

Each of the reference voltage source circuits 12F-1 to 12F-3 is provided with resistors R91 and R92, five switches 91, and five constant current sources 92, which are configured in a manner similar to that of the resistors R81 and R82, the switches 81, and the constant current sources 82 of the control voltage source circuit 11F. The resistors R91 and R92 have the same resistance of R90. Each switch 91 is a single-pole double-throw switch. Five series circuits, each including the switch 91 and the constant current source 92, are connected parallel to each other. Each switch 91 is controlled to connect a corresponding constant current source 92 to one of the output terminals t and c, in accordance with a reference voltage to be generated. The reference voltage source circuits 12F-1 is configured in advance such that the switches 91 connect the five constant current sources 92 to the output terminal t, thus generating the control voltage Vr1 at the output terminal t, and generating the control voltage Vr6 at the output terminal c. The reference voltage source circuits 12F-2 is configured in advance such that the switches 91 connect four constant current sources 92 to the output terminal t, thus generating the control voltage Vr2 at the output terminal t, and generating the control voltage Vr5 at the output terminal c. The reference voltage source circuits 12F-3 is configured in advance such that the switches 91 connect three constant current sources 92 to the output terminal t, thus generating the control voltage Vr3 at the output terminal t, and generating the control voltage Vr4 at the output terminal c.

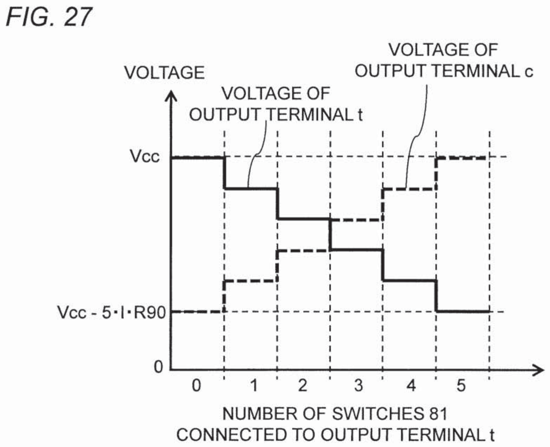

Fig. 27 is a diagram explaining operations of the reference voltage source circuits 12F-1 to 12F-3 of Fig. 25. When all the constant current sources 92 are connected to the output terminal c, the voltage at the output terminal t is equal to the power source voltage Vcc, and the voltage at the output terminal c is equal to Vcc - 5 x I x R80. Per increasing the number of the constant current sources 92 connected to the output terminal t, the voltage at the output terminal t decreases by I x R90, and the voltage at the output terminal c increases by I x R90. When all the constant current sources 92 are connected to the output terminal t, the voltage at the output terminal t is equal to Vcc - 5 x I x R80, and the voltage at the output terminal c is equal to the power source voltage Vcc. Thus, in each of the reference voltage source circuits 12F-1 to 12F-3, the voltages at the output terminals t and c vary in a complemental manner. Therefore, the reference voltage source circuits 12F-1 to 12F-3 can generate the six reference voltages Vr1 to Vr6 by connecting different numbers of constant current sources 92 to the output terminals t.

According to the sixth embodiment, since each reference voltage source circuit generates two reference voltages, the number of the reference voltage source circuits can be reduced by half as compared with that of the fifth embodiment. Thus, it is possible to reduce the circuit size and power consumption of the phase shifter 1F than those of the phase shifter 1E.

Each of the reference voltage source circuits 12F-1 to 12F-3 has components and a layout at least partially identical to components and a layout of the control voltage source circuit 11F. Therefore, it is possible to make the circuits less susceptible to variations in manufacturing process of components, and variations in power source voltage. In addition, the control voltage source circuit 11F and the reference voltage source circuits 12F-1 to 12F-3 may be arranged close to each other, in order to make the circuits less susceptible to variations in characteristics of components due to temperature.

Since the control voltage source circuit 11F and the reference voltage source circuits 12F-1 to 12F-3 can be implemented by the switches 81 and 91 having the same characteristics with each other, and the constant current sources 82 and 92 having the same characteristics with each other, integrating them can reduce variations in manufacturing process. In addition, in a case where the control voltage source circuit 11F and the reference voltage source circuits 12F-1 to 12F-3 are implemented by the same types of circuit components, the control voltage Vc(k) and the reference voltages Vr1 to Vr6 are shifted in the same direction in accordance with variations in the power supply voltage and the temperature. Since the control voltage Vc(k) and the reference voltages Vr1 to Vr6 are supplied to the differential amplifiers 31 to 33 and 41 to 43, the voltage shifts in the same direction can be canceled due to a high common mode rejection ratio (CMRR) of the differential amplifiers.

Since all the control voltage source circuit 11F and the reference voltage source circuits 12F-1 to 12F-3 are configured as current-output digital-to-analog converters, it is possible to easily determine design parameters associated with voltages to be supplied to the folding circuits 13 and 14.

According to the sixth embodiment, the control voltage source circuit 11F generates the one control voltage Vc(k), and the three reference voltage source circuits 12F-1 to 12F-3 generate the six reference voltages Vr1 to Vr6. The folding circuits 14 is supplied with the reference voltagwes Vr1, Vr3, and Vr5, and the folding circuits 13 is supplied with the different reference voltages Vr2, Vr4, and Vr6, and thus, a phase difference occurs between the output signals Vsin(k) and Vcos(k).

[SEVENTH EMBODIMENT]

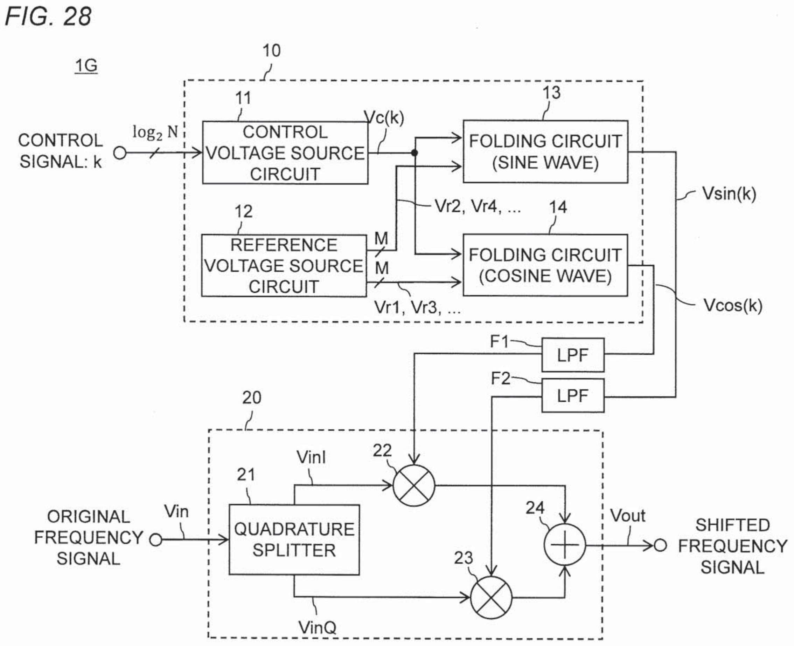

Fig. 28 is a block diagram showing a configuration of a phase shifter 1G provided with the signal generation circuit 10 according to a seventh embodiment. The phase shifter 1G is provided with, in addition to the components of the phase shifter 1 of Fig. 1, low-pass filters (LPF) F1 and F2 inserted between the signal generation circuit 10 and the quadrature modulation circuit 20. The low-pass filters F1 and F2 reduce signal components of the output signals Vsin(k) and Vcos(k) of the signal generation circuit 10, the signal components having frequencies higher than a predetermined frequency. There is an issue in which, when controlling phase shifters at high speed in a phased array antenna apparatus using the phase shifters, spurious frequencies (unnecessary waves) occur in an output signal of the phased array antenna apparatus. By inserting the low-pass filters F1 and F2 between the signal generation circuit 10 and the quadrature modulation circuit 20, it is possible to smoothly change a phase of the phase shifter 1G, thus preventing spurious frequencies.

[EIGHTH EMBODIMENT]

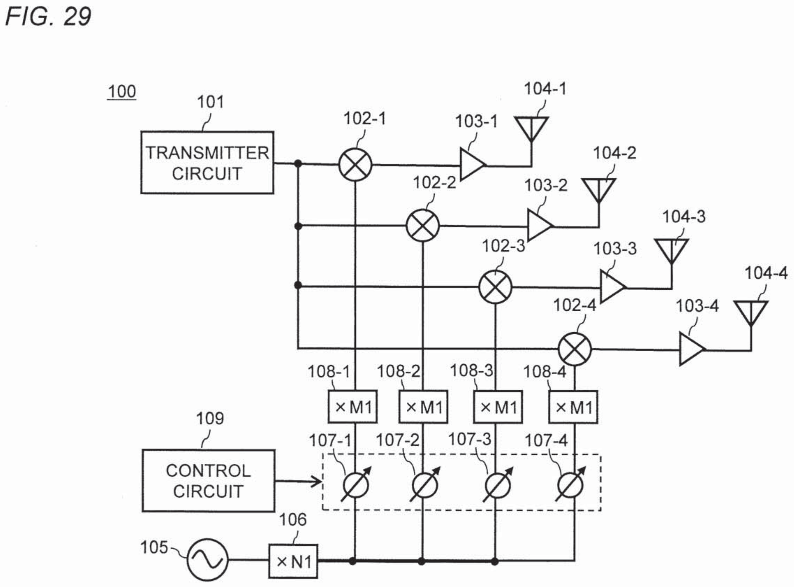

Fig. 29 is a block diagram showing a configuration of a wireless communication apparatus 100 according to an eighth embodiment. The wireless communication apparatus 100 is provided with a transmitter circuit 101, mixers 102-1 to 102-4, amplifiers 103-1 to 103-4, antenna elements 104-1 to 104-4, a frequency synthesizer 105, a frequency multiplier 106, phase shifters 107-1 to 107-4, frequency multipliers 108-1 to 108-4, and a control circuit 109.

The transmitter circuit 101 sends a baseband signal to the mixers 102-1 to 102-4, the baseband signal including data to be transmitted.

The frequency synthesizer 105 generates a high-frequency signal having a predetermined frequency. The frequency multiplier 106 multiplies a frequency of the high-frequency signal generated by the frequency synthesizer 105, and then sends the output signal to the phase shifters 107-1 to 107-4.

Each of the phase shifters 107-1 to 107-4 is configured in a manner similar to that of the phase shifters 1, 1A to 1C, 1G according to the first to fourth embodiments. The phase shifters 107-1 to 107-4 are provided with control signals k1 to k4 from the control circuit 109, respectively. The phase shifters 107-1 to 107-4 change the phases of the high-frequency signals inputted from the frequency multiplier 106, in accordance with the control signals k1 to k4, respectively. The control circuit 109 changes the phases of the high-frequency signals arbitrarily and independently, using the control signals k1 to k4.

The frequency multipliers 108-1 to 108-4 multiply the frequencies of the high-frequency signals outputted from the phase shifters 107-1 to 107-4, and then send the output signals to the mixers 102-1 to 102-4.

The mixers 102-1 to 102-4 modulates the high-frequency signals (radio frequency signals) inputted from the frequency multipliers 108-1 to 108-4, with the baseband signal inputted from the transmitter circuit 101. The output signals of the mixers 102-1 to 102-4 are respectively amplified by the amplifiers 103-1 to 103-4, and then, emitted through the antenna elements 104-1 to 104-4.

The antenna elements 104-1 to 104-4 operate as a phased array antenna apparatus, since the phase shifters 107-1 to 107-4 change the phases of the radio frequency signals to be transmitted. By accurately changing the phases of the radio frequency signals using the phase shifters 107-1 to 107-4, it is possible to improve the directivity of the antenna apparatus.

Although Fig. 29 shows the wireless communication apparatus 100 provided with the transmitter circuit 101, the phase shifters 1, 1A to 1C, 1G according to the first to seventh embodiments can be similarly applied to a wireless communication apparatus provided with a receiver circuit. In a case where the wireless communication apparatus is provided with a receiver circuit, a direction of arrival may be estimated based on the received signals, or the beam may be directed in the direction of arrival using phase shifters.

According to the eighth embodiment, it is possible to provide a wireless communication apparatus using a high-frequency band, such as a millimeter wave and a terahertz wave.

[OTHER EMBODIMENTS]

The above-described embodiments and variations may be arbitrarily combined with each other.

In the example of Fig. 2, the reference voltages Vr1 to Vr6 for the differential amplifiers 31 to 33 and 41 to 43 are set in the order of Vr1 < Vr2 < Vr3 < Vr4 < Vr5 < Vr6. However, the reference voltages Vr1 to Vr6 may be set in other orders, for example, in the order of Vr2 < Vr1 < Vr4 < Vr3 < Vr6 < Vr5.

Although Fig. 1 and others illustrate the case where the signal generation circuit 10 generates both the sine wave and the cosine wave, the technique described herein is also applicable to a case of generating only one of the sine wave and the cosine wave. In that case, the signal generation circuit is provided with only one of the folding circuits 13 and 14. The output signal of the signal generation circuit may be provided to any circuit that uses a signal level corresponding to a predetermined phase of a sine wave or a cosine wave, for example, a direct digital synthesizer that digitally generates a sine wave signal or a cosine wave signal.

INDUSTRIAL APPLICABILITY

The signal generation circuit, the phase shifter, the array antenna apparatus, and the wireless communication apparatus according to one aspect of the present disclosure are applicable to, for example, a base station or a mobile station of a wireless communication system. The signal generation circuit, the phase shifter, the array antenna apparatus, and the wireless communication apparatus according to one aspect of the present disclosure are applicable to, for example, phase shifter units for a phased array antenna apparatus that is planned to be incorporated into satellite communication and a meteorological radar.

REFERENCE SIGNS LIST

1, 1A to 1C, 1E to 1G: phase shifter
10, 10A to 10F: signal generation circuit
11, 11a, 11b, 11Bb, 11F: control voltage source circuit
12, 12A, 12C1 to 12C-3, 12D-2 to 12D-3, 12E-1 to 12E-6, 12F-1 to 12F-3: reference voltage source circuit
13, 14: folding circuit
15: adder
20: quadrature modulation circuit
21: quadrature splitter
22, 23: multiplier
24: combiner
31 to 33: differential amplifier
41 to 43: differential amplifier
51: constant current source
61, 63: switch
62, 64: constant current source
71, 73: switch
72, 74: constant current source
81: switch
82: constant current source
91: switch
92: constant current source
100: wireless communication apparatus
101: transmitter circuit

102-1 to 102-4: mixer
103-1 to 103-4: amplifier
104-1 to 104-4: antenna element
105: frequency synthesizer
106: frequency multiplier
107-1 to 107-4: phase shifter
108-1 to 108-4: frequency multiplier
109: control circuit
F1, F2: low-pass filter (LPF)
R0, R21 to R28, R21A to R24A, R31, R32, R41, R42, Ra to Rd: resistor
Q1, Q2: bipolar transistor
Q1A, Q2A: field effect transistor

**Claims**

1. A signal generation circuit comprising:

   at least one control voltage source circuit that generates a control voltage having one of a plurality of predetermined voltage values, in accordance with an inputted control signal;
   at least one reference voltage source circuit that generates a plurality of predetermined reference voltages; and
   at least one folding circuit that generates an output signal based on differences between the control voltage and the plurality of reference voltages, the output signal having a signal level corresponding to a predetermined phase of a sine wave or a cosine wave,
   wherein the control voltage source circuit comprises a parallel circuit of a plurality of first constant current sources, each of the first constant current sources being turned on or off in accordance with the control signal.

2. The signal generation circuit according to claim 1, comprising:

   a first folding circuit that generates a first output signal having a signal level corresponding to a predetermined phase of a sine wave; and
   a second folding circuit that generates a second output signal having a signal level corresponding to a predetermined phase of a cosine wave.

3. The signal generation circuit according to claim 2, wherein the first folding circuit comprises:

   a first differential amplifier that compares the control voltage with a first reference voltage to generate a first differential output signal;
   a second differential amplifier that compares the control voltage with a second reference voltage higher than the first reference voltage to generate a second differential output signal; and
   a third differential amplifier that compares the control voltage with a third reference voltage higher than the second reference voltage to generate a third differential output signal,
   wherein the second folding circuit comprises:

   a fourth differential amplifier that compares the control voltage with a fourth reference voltage to generate a fourth differential output signal;
   a fifth differential amplifier that compares the control voltage with a fifth reference voltage higher than the fourth reference voltage to generate a fifth differential output signal; and
   a sixth differential amplifier that compares the control voltage with a sixth reference voltage higher than the fifth reference voltage to generate a sixth differential output signal,
   wherein the first output signal is a sum of the first and third differential output signals and an inverted signal of the second differential output signal, and
   wherein the second output signal is a sum of the fourth and sixth differential output signals and an inverted signal of the fifth differential output signal.

4. The signal generation circuit according to claim 3,

   wherein the control voltage source circuit supplies one common control voltage to the first to sixth differential amplifiers, and
wherein the first to sixth reference voltages are different from each other.

5. The signal generation circuit according to claim 4,
wherein the reference voltage source circuit comprises a plurality of resistors and a plurality of first taps, and generates the first to sixth reference voltages at the plurality of taps.

6. The signal generation circuit according to claim 4,

wherein the signal generation circuit comprises first to sixth reference voltage source circuits that generate the first to sixth reference voltages, respectively,
wherein each of the first to sixth reference voltage source circuits comprises a parallel circuit of a plurality of second constant current sources, each of the second constant current sources being turned on or off in accordance with a reference voltage to be generated, and
wherein each of the first to sixth reference voltage source circuits has components and a layout at least partially identical to components and a layout of the control voltage source circuit.

7. The signal generation circuit according to claim 4,
wherein the signal generation circuit comprises:

a first reference voltage source circuit that generates the first and sixth reference voltages,
a second reference voltage source circuit that generates the second and fifth reference voltages, and
a third reference voltage source circuit that generates the third and fourth reference voltages,
wherein the first reference voltage source circuit comprises a parallel circuit of a plurality of second constant current sources, each of the second constant current sources being connected to one of the first and sixth differential amplifiers in accordance with a reference voltage to be generated,
wherein the second reference voltage source circuit comprises a parallel circuit of a plurality of third constant current sources, each of the third constant current sources being connected to one of the second and fifth differential amplifiers in accordance with a reference voltage to be generated,
wherein the third reference voltage source circuit comprises a parallel circuit of a plurality of fourth constant current sources, each of the fourth constant current sources being connected to one of the third and fourth differential amplifiers in accordance with a reference voltage to be generated, and
wherein each of the first to third reference voltage source circuits has components and a layout at least partially identical to components and a layout of the control voltage source circuit.

8. The signal generation circuit according to claim 3,
wherein the signal generation circuit comprises:

a first control voltage source circuit that generates and supplies a first control voltage to the first to third differential amplifiers, and
a second control voltage source circuit that generates and supplies a second control voltage to the fourth to sixth differential amplifiers, the first and second control voltages having a voltage difference that is constant modulo a difference between a maximum and a minimum of the first control voltage, and
wherein the fourth to sixth reference voltages are equal to the first to third reference voltages, respectively.

9. The signal generation circuit according to claim 8,
wherein the reference voltage source circuit comprises a plurality of resistors and a plurality of first taps, and generates the first to third reference voltages at the plurality of taps.

10. The signal generation circuit according to claim 8,

wherein the signal generation circuit comprises first to third reference voltage source circuits that generate the first to third reference voltages, respectively,
wherein each of the first to third reference voltage source circuits comprises a parallel circuit of a plurality of second constant current sources, each of the second constant current sources being turned on or off in accordance with a reference voltage to be generated, and
wherein each of the first to third reference voltage source circuits has components and a layout at least partially identical to components and a layout of the control voltage source circuits.

**11.** The signal generation circuit according to one of claims 8 to 10,

wherein the first control voltage source circuit generates the first control voltage in accordance with the control signal, and

wherein the second control voltage source circuit generates the second control voltage in accordance with a signal which is a sum of the control signal and a predetermined value.

**12.** The signal generation circuit according to one of claims 8 to 10,
wherein the second control voltage source circuit comprises a third constant current source that constantly generates a current corresponding to the voltage difference between the first and second control voltages.

**13.** The signal generation circuit according to claim 3,
wherein each of the first to sixth differential amplifiers comprises a pair of bipolar transistors or a pair of field effect transistors.

**14.** A phase shifter comprising: .

the signal generation circuit according to claim 2;

a quadrature splitter that splits an input signal into an in-phase signal and a quadrature-phase signal;

a first multiplier that multiplies the in-phase signal by the second output signal of the signal generation circuit to generate a first multiplication signal;

a second multiplier that multiplies the quadrature-phase signal by the first output signal of the signal generation circuit to generate a second multiplication signal; and

a combiner that combines the first multiplication signal and the second multiplication signal with each other.

**15.** The phase shifter according to claim 14, further comprising
a low-pass filter that reduces signal components of the first and second output signals of the signal generation circuit, the signal components having frequencies higher than a predetermined frequency.

**16.** An array antenna apparatus comprising:

a plurality of antenna elements;

a plurality of mixers; and

a plurality of the phase shifters according to claim 14.

**17.** A wireless communication apparatus comprising:

the array antenna apparatus according to claim 16; and

a communication circuit.

FIG. 1

<u>1</u>

CONTROL SIGNAL: k  $\log_2 N$

10

11 — CONTROL VOLTAGE SOURCE CIRCUIT — Vc(k)

12 — REFERENCE VOLTAGE SOURCE CIRCUIT — M, M

13 — FOLDING CIRCUIT (SINE WAVE) — Vsin(k)

14 — FOLDING CIRCUIT (COSINE WAVE) — Vcos(k)

Vr2, Vr4, …

Vr1, Vr3, …

20

ORIGINAL FREQUENCY SIGNAL  Vin

21 — QUADRATURE SPLITTER

VinI

VinQ

22

23

24

Vout

SHIFTED FREQUENCY SIGNAL

21

FIG. 2

EP 4 657 754 A1

FIG. 3

FIG. 4

FIG. 5

31~33, 41~43

FIG. 6

31A~33A, 41A~43A

FIG. 7

CURRENT Ix

Vtran

Vr

CONTROL
VOLTAGE Vc

FIG. 8

CURRENT
Isum'

Vtran          Vtran

Vr2a          Vr4a
CONTROL
VOLTAGE Vc

CURRENT
Isum'

Vtran    Vtran

Vr2b      Vr4b
CONTROL
VOLTAGE Vc

CURRENT
Isum'

Vr2c  Vr4c
CONTROL
VOLTAGE Vc

FIG. 9

FIG. 10

FIG. 11

EP 4 657 754 A1

FIG. 12

EP 4 657 754 A1

*FIG. 13*

FIG. 14

EP 4 657 754 A1

*FIG. 15*

FIG. 16

FIG. 17

FIG. 18

FIG. 19

EP 4 657 754 A1

FIG. 20

FIG. 21

## FIG. 22

EP 4 657 754 A1

FIG. 23

10E

EP 4 657 754 A1

FIG. 24

FIG. 25

FIG. 26

10F

EP 4 657 754 A1

FIG. 27

## FIG. 28

EP 4 657 754 A1

FIG. 29

## INTERNATIONAL SEARCH REPORT

International application No.

**PCT/JP2023/037745**

| A. | CLASSIFICATION OF SUBJECT MATTER |
|---|---|

*H03H 11/20*(2006.01)i; *H01Q 3/38*(2006.01)i; *H01Q 21/00*(2006.01)i
FI:     H03H11/20 Z; H01Q3/38; H01Q21/00

According to International Patent Classification (IPC) or to both national classification and IPC

| B. | FIELDS SEARCHED |
|---|---|

Minimum documentation searched (classification system followed by classification symbols)

H03H11/20; H01Q3/38; H01Q21/00

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| Y | WO 2010/021280 A1 (NIPPON TELEGRAPH AND TELEPHONE CORPORATION) 25 February 2010 (2010-02-25)<br>paragraphs [0022]-[0154], fig. 1-40 | 1-6, 13-17 |
| A | paragraphs [0022]-[0154], fig. 1-40 | 7-12 |
| Y | JP 2003-223702 A (HITACHI, LTD.) 08 August 2003 (2003-08-08)<br>paragraph [0017], fig. 8 | 1-6, 13-17 |
| A | paragraph [0017], fig. 8 | 7-12 |

☐ Further documents are listed in the continuation of Box C.     ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **30 November 2023** | **12 December 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**
Information on patent family members

International application No.

**PCT/JP2023/037745**

| Patent document cited in search report | | | Publication date (day/month/year) | Patent family member(s) | | | Publication date (day/month/year) |
|---|---|---|---|---|---|---|---|
| WO | 2010/021280 | A1 | 25 February 2010 | US paragraphs [0067]-[0219], fig. 1-40 | 2011/0150495 | A1 | |
| | | | | EP | 2326002 | A1 | |
| | | | | CN | 102124649 | A | |
| JP | 2003-223702 | A | 08 August 2003 | US paragraph [0041], fig. 8 | 2003/0142432 | A1 | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• JP 2003133906 A